# EUROPEAN PATENT APPLICATION

(11) **EP 4 586 411 A1**
(43) Date of publication of application: **16.07.2025**
(21) Application number: 24783548.1
(22) Date of filing: 11.10.2024
(51) Int. Cl.: H01R 12/71, H01R 12/70, H01R 13/6581, H05K 1/14

(54) **ELECTRONIC DEVICE COMPRISING CONNECTOR**

(30) Priority: 11.10.2023 KR 20230135373; 29.12.2023 KR 20230196551
(71) Applicant: SAMSUNG ELECTRONICS CO., LTD., Yeongtong-gu Suwon-si, Gyeonggi-do 16677 (KR)
(72) Inventor: LEE, Donghyeok, Suwon-si Gyeonggi-do 16677 (KR); KO, Byungkuk, Suwon-si Gyeonggi-do 16677 (KR); KIM, Daehyun, Suwon-si Gyeonggi-do 16677 (KR); KIM, Moonyung, Suwon-si Gyeonggi-do 16677 (KR); JANG, Seokmin, Suwon-si Gyeonggi-do 16677 (KR); JO, Kyunghwan, Suwon-si Gyeonggi-do 16677 (KR); JIN, Myoungdae, Suwon-si Gyeonggi-do 16677 (KR); HONG, Hyunju, Suwon-si Gyeonggi-do 16677 (KR)
(74) Representative: Gulde & Partner
(86) International application number: PCT/KR2024/015385
(87) International publication number: WO 2025/080008

(57) **Abstract**

According to an embodiment of the disclosure, there may be provided an electronic device. An electronic device may comprise a first printed circuit board including a first surface, a second surface opposite to the first surface, and an opening penetrating the first surface and the second surface, a first connector at least partially disposed in the opening, at least partially supported on the first surface or the second surface of the first printed circuit board, and electrically connected to the first printed circuit board, and a second connector, and comprising a second printed circuit board electrically connected to the first printed circuit board through coupling of the first connector and the second connector.

## Description

### [Technical Field]

Various embodiments of the disclosure may provide an electronic device including a connector configured to be disposed in an opening of a printed circuit board.

### [Background Art]

Advancing information communication technology and semiconductor technology accelerate the spread and use of various electronic devices. In particular, recent electronic devices are being developed to carry out communication while carried on. Further, electronic devices may output stored information as voices or images. As electronic devices are highly integrated, and high-speed or high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, and a scheduling and e-wallet function. These electronic devices have been downsized to be conveniently carried by users.

Use of an electronic device with a larger screen may give more convenience in, e.g., web browsing or multimedia playing. A larger display may be adopted to output a larger screen. However, this way may be limited by the portability of the electronic device. To overcome these limitations, electronic devices equipped with a foldable or bendable, slidable, or rollable display are being recently disclosed.

Meanwhile, for a single electronic device to implement various functions, the electronic device may come equipped with a component (e.g., a processor) capable of performing high-performance operation and a component (e.g., memory) for storing various data. There is ongoing research on an aspect for increasing the efficiency of the mounting space in equipping such components (e.g., processor and/or memory) in the electronic device.

The above-described information may be provided as related art for the purpose of helping understanding of the disclosure. No claim or determination is made as to whether any of the foregoing is applicable as background art in relation to the disclosure.

### [Disclosure of Invention]

### [Solution to Problems]

According to an embodiment of the disclosure, an electronic device is provided. An electronic device comprises a first printed circuit board including a first surface, a second surface opposite to the first surface, and an opening penetrating the first surface and the second surface, a first connector at least partially disposed in the opening, at least partially supported on the first surface or the second surface of the first printed circuit board, and electrically connected to the first printed circuit board, and comprising a second printed circuit board including a second connector and electrically connected to the first printed circuit board through coupling of the first connector and the second connector.

According to an embodiment of the disclosure, an electronic device is provided. An electronic device may comprise a first printed circuit board including an opening, a first connector disposed in the opening, and a second printed circuit board including a second connector configured to be coupled with the first connector. Here, the first connector may include a first plate and a first terminal portion and a first conductive portion formed on one surface of the first plate. The second connector may include a second conductive portion configured to contact the first conductive portion.

According to an embodiment of the disclosure, an electronic device is provided. An electronic device may comprise a first printed circuit board including a 1-1th flexible printed circuit board including a line having a first signal characteristic and an opening and a 1-2th flexible printed circuit board including a line having a second signal characteristic different from the first signal characteristic, a first connector disposed in the opening, and a second printed circuit board including a second connector and including a 2-1th flexible printed circuit board electrically connected to the 1-1th flexible printed circuit board through coupling of the first connector and the second connector and a 2-2th flexible printed circuit board electrically connected to the 1-2th flexible printed circuit board. The first connector may be electrically connected to the 1-1th flexible printed circuit board, and the second connector may be electrically connected to the 2-1th flexible printed circuit board.

### [Brief Description of Drawings]

The foregoing and other aspects, configurations, and/or advantages of an embodiment of the disclosure will be more apparent from the following detailed description taken in conjunction with the accompanying drawings.
FIG. 1 is a view illustrating an electronic device in a network environment according to various embodiments;
FIG. 2 is a view illustrating a state in which a second display area of a display is received in a housing according to an embodiment;
FIG. 3 is a view illustrating a state in which a second display area of a display is visually exposed to the outside of a housing according to an embodiment;
FIG. 4 is an exploded perspective view illustrating an electronic device according to an embodiment;
FIG. 5A is a view illustrating a portion of an electronic device according to an embodiment;
FIG. 5B is an enlarged view EV1 of a flexible printed circuit board portion in FIG. 5A;
FIG. 6A is a view illustrating a state of a 1-1th flexible printed circuit board corresponding to a slide-in state of an electronic device according to an embodiment;
FIG. 6B is a view illustrating a state of a 1-1th flexible printed circuit board corresponding to a slide-out state of an electronic device according to an embodiment;
FIG. 6C is a view illustrating a state of a 1-2th flexible printed circuit board corresponding to a slide-in state of an electronic device according to an embodiment;
FIG. 6D is a view illustrating a state of a 1-2th flexible printed circuit board corresponding to a slide-out state of an electronic device according to an embodiment;
FIG. 7A is a view illustrating a state of a 1-1th flexible printed circuit board and a 1-2th flexible printed circuit board connected to each other in a slide-in state of an electronic device according to an embodiment;
FIG. 7B is a view illustrating a state of a 1-1th flexible printed circuit board and a 1-2th flexible printed circuit board connected to each other in a slide-out state of an electronic device according to an embodiment;
FIG. 8 is a view illustrating a sub circuit board and a second printed circuit board according to an embodiment;
FIG. 9A is a view illustrating a sub circuit board and a second printed circuit board according to an embodiment;
FIG. 9B is a view illustrating a sub circuit board and a second printed circuit board according to an embodiment;
FIG. 10 is a view illustrating an arrangement structure of various connectors disposed on a 1-1th flexible printed circuit board according to an embodiment;
FIG. 11 is a view illustrating an arrangement structure of various connectors including a first connector assembly disposed on a 1-1th flexible printed circuit board according to an embodiment;
FIG. 12 is a cross-sectional view illustrating an arrangement structure of a first connector assembly disposed on a first printed circuit board according to an embodiment;
FIG. 13 is a view illustrating a process of disposing a first connector assembly and another connector on a 1-1th flexible printed circuit board according to an embodiment;
FIG. 14A is a cross-sectional view illustrating a state in which a first connector assembly is coupled according to an embodiment;
FIG. 14B is a cross-sectional view illustrating a state in which a first connector assembly is coupled according to an embodiment;
FIG. 14C is a cross-sectional view illustrating a state in which a first connector assembly is coupled according to an embodiment;
FIG. 15 is a perspective view illustrating a first connector according to an embodiment;
FIG. 16A is a perspective view illustrating a second surface of a first rigid portion according to an embodiment;
FIG. 16B is a perspective view illustrating a second surface of a first rigid portion according to an embodiment;
FIG. 16C is a perspective view illustrating a second surface of a first rigid portion according to an embodiment;
FIG. 17A is a perspective view illustrating a first connector according to an embodiment;
FIG. 17B is a perspective view illustrating a portion except for a first conductive portion in a first connector according to an embodiment;
FIG. 17C is a perspective view illustrating a portion except for a first conductive portion and a first terminal portion in a first connector according to an embodiment;
FIG. 17D is a perspective view illustrating a portion except for a first conductive portion, a first terminal portion, and a first plate in a first connector according to an embodiment;
FIG. 18A is a perspective view illustrating a first connector further including a second reinforcing member according to an embodiment;
FIG. 18B is a perspective view illustrating a state in which a first connector further including a second reinforcing member is coupled to a first rigid portion according to an embodiment;
FIG. 19 is a perspective view illustrating a state of a first rigid portion further including an opening for a second reinforcing member according to an embodiment;
FIG. 20 is a perspective view illustrating a state of a first rigid portion according to an embodiment;
FIG. 21 is a cross-sectional view illustrating an arrangement structure of a first connector assembly disposed on a first printed circuit board according to an embodiment;
FIG. 22 is a cross-sectional view illustrating a state in which a component is disposed on a first connector according to an embodiment; and
FIG. 23 is a cross-sectional view illustrating a state in which a component is disposed on a first connector according to an embodiment.
Throughout the drawings, like reference numerals may be assigned to like parts, components, and/or structures.

### [Mode for the Invention]

Unlike general bar-type electronic devices with a fixed shape, electronic devices with a slidable (or rollable) display (hereinafter, "rollable electronic devices") may include a driving structure including a motor and gears, and a circuit board for disposing them. The components may be electrically connected to each other via various connectors. However, the rollable electronic device may be hard to design due to an insufficient space caused as the area occupied by the connector increases relative to the component mounting area.

The disclosure may provide an electronic device including a connector in which an opening is formed in a printed circuit board, and a contact portion is formed in the opening. The disclosure may provide an electronic device with enhanced space utilization by receiving a connector in an opening to thereby allow an additional component or connector to be superposed at the position where the connector is to be disposed.

The following description taken in conjunction with the accompanying drawings may provide an understanding of various exemplary implementations of the disclosure, including claims and their equivalents. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

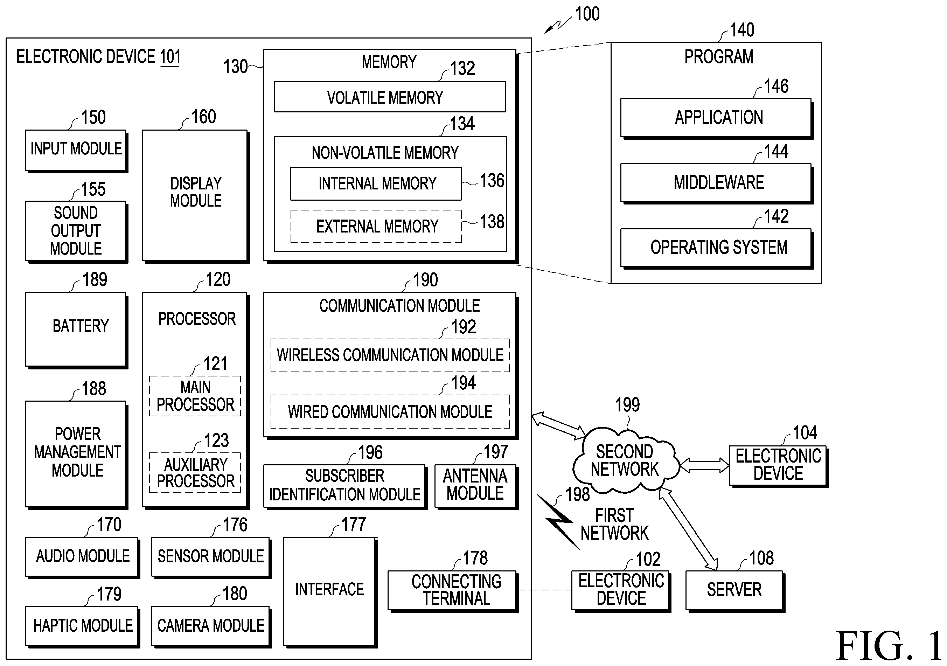

FIG. 1 is a view illustrating an electronic device in a network environment according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as BluetoothTM, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. **In** another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

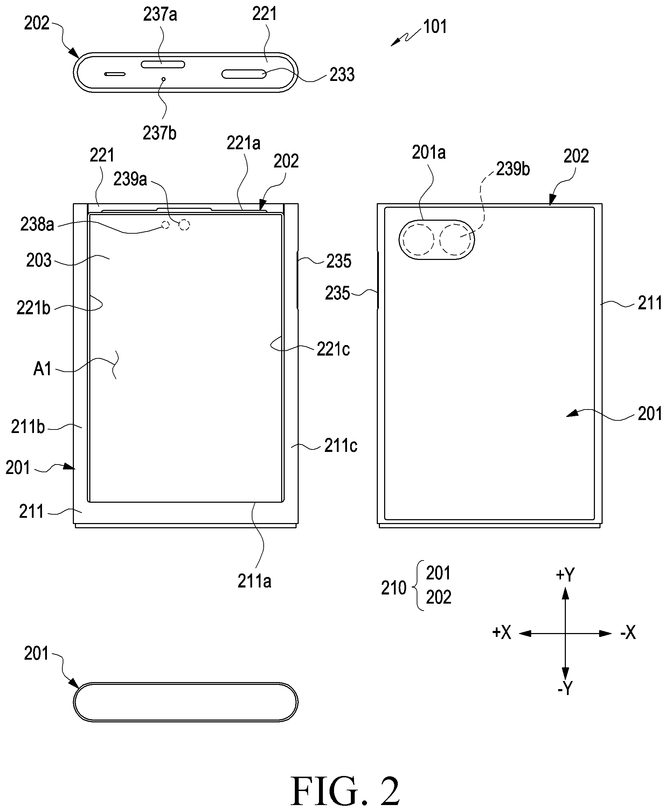

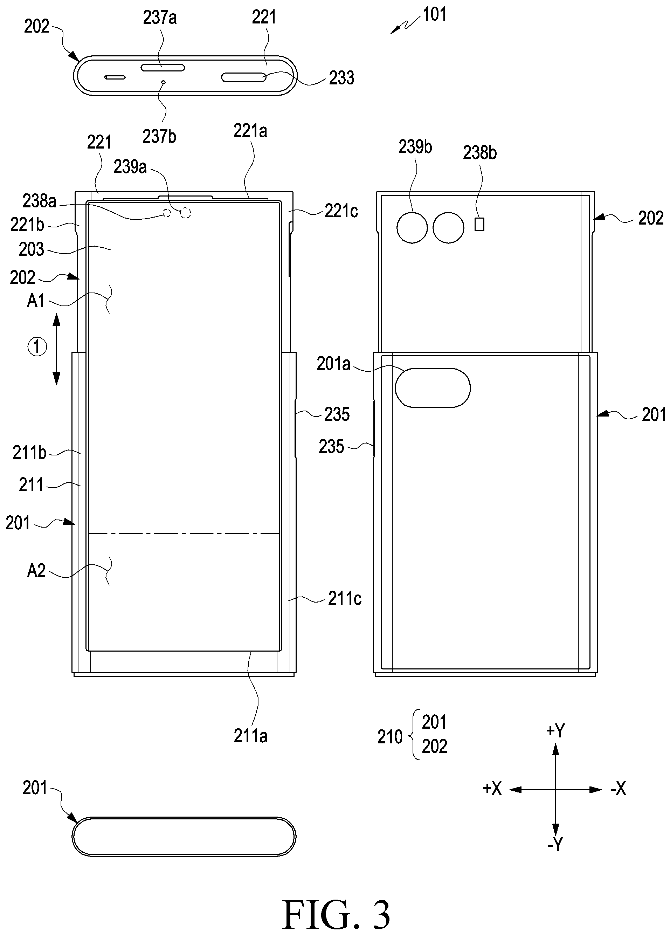

FIG. 2 is a view illustrating a state in which a second display area of a display is received in a housing according to an embodiment. FIG. 3 is a view illustrating a state in which a second display area of a display is visually exposed to the outside of a housing according to an embodiment.

FIGS. 2 and 3 illustrate a structure in which the display 203 (e.g., flexible display, foldable display, and/or rollable display) is extended in the length direction (e.g., +Y direction) when the electronic device 101 is viewed from the front. However, the extending direction of the display 203 is not limited to one direction (e.g., +Y direction). For example, the extending direction of the display 203 may be changed in design to be extendable in the upper direction (+Y direction), right direction (e.g., +X direction), left direction (e.g., -X direction), and/or lower direction (e.g., -Y direction).

The state illustrated in FIG. 2 may be referred to as a slide-in state of the electronic device 101 or a state in which the second display area A2 of the display 203 is closed. The state illustrated in FIG. 3 may be referred to as a slide-out state of the electronic device 101 or a state in which the second display area A2 of the display 203 is open.

Referring to FIGS. 2 and 3, the electronic device 101 may include a housing 210. The housing 210 may include a first housing part 201 and a second housing part 202 disposed to be movable relative to the first housing part 201. According to an embodiment, the electronic device 101 may be interpreted as having a structure in which the first housing part 201 is disposed to be slidable with respect to the second housing part 202. According to an embodiment, the second housing part 202 may be disposed to perform reciprocating motion by a predetermined distance in a predetermined direction with respect to the first housing part 201, for example, a direction indicated by an arrow ① of FIG. 3.

According to an embodiment, the second housing part 202 may be referred to as a slide portion or a slide housing, and may be movable relative to the first housing part 201. According to an embodiment, the first housing part 201 and/or the second housing part 202 may receive various electrical and electronic components, such as a circuit board or a battery.

According to an embodiment, the slide-in state of the electronic device 101 (or the slide-out state of the electronic device 101) may be changed into the slide-out state of the electronic device 101 (or the slide-in state of the electronic device 101) based on a predefined user input. For example, the slide-in state of the electronic device 101 (or the slide-out state of the electronic device 101) may be changed into the slide-out state (or the slide-in state of the electronic device 101) in response to a user input to a physical button exposed through a portion of the first housing part 201 or a portion of the second housing part 202. For example, the slide-in state (or the slide-out state of the electronic device 101) may be changed into the slide-out state (or the slide-in state of the electronic device 101) in response to a touch input to an executable object displayed in the screen display area (e.g., the first display area A1). For example, the user's input may be at least one of a touch input that has a contact point on the screen display area (e.g., the first display area A1) and has a pressing strength of a reference strength or more, a voice input received through the microphone, an external force applied to the first housing part 201 and/or the second housing part 202 to move the second housing part 202 with respect to the first housing part 201, or a user input identified by an external electronic device (e.g., an earset or a smart watch) connected to the electronic device 101. However, the slide in-out operations of the electronic device 101 are not limited thereto.

According to an embodiment, the first housing part 201 may receive a motor, a speaker, and/or a SIM socket. The first housing part 201 may receive a circuit board (e.g., a sub circuit board) for mounting the motor, speaker, and/or SIM socket. Here, the components mounted on the circuit board may be other various components than the above-described components, and are not limited. The second housing part 202 may receive a circuit board (e.g., a main circuit board) where electronic components such as an application processor (AP) and a communication processor (CP) are mounted. The circuit board of the first housing part 201 may be connected to the circuit board of the second housing part 202. However, the disclosure is not limited to the above-described structure. According to an embodiment, the first housing part 201 may receive a circuit board (e.g., main circuit board) where electronic components such as an AP and a CP are mounted, and the second housing part 202 may receive a circuit board (e.g., sub circuit board) for mounting a motor, a speaker, and/or a SIM socket.

According to an embodiment, the first housing part 201 may include a first cover member 211 (e.g., a main case). The first cover member 211 may include a 1-1th sidewall 211a, a 1-2th sidewall 211b extending from the 1-1th sidewall 211a, and a 1-3th sidewall 211c extending from the 1-1th sidewall 211a and substantially parallel to the 1-2th sidewall 211b. According to an embodiment, the 1-2th sidewall 211b and the 1-3th sidewall 211c may be formed substantially perpendicular to the 1-1th sidewall 211a.

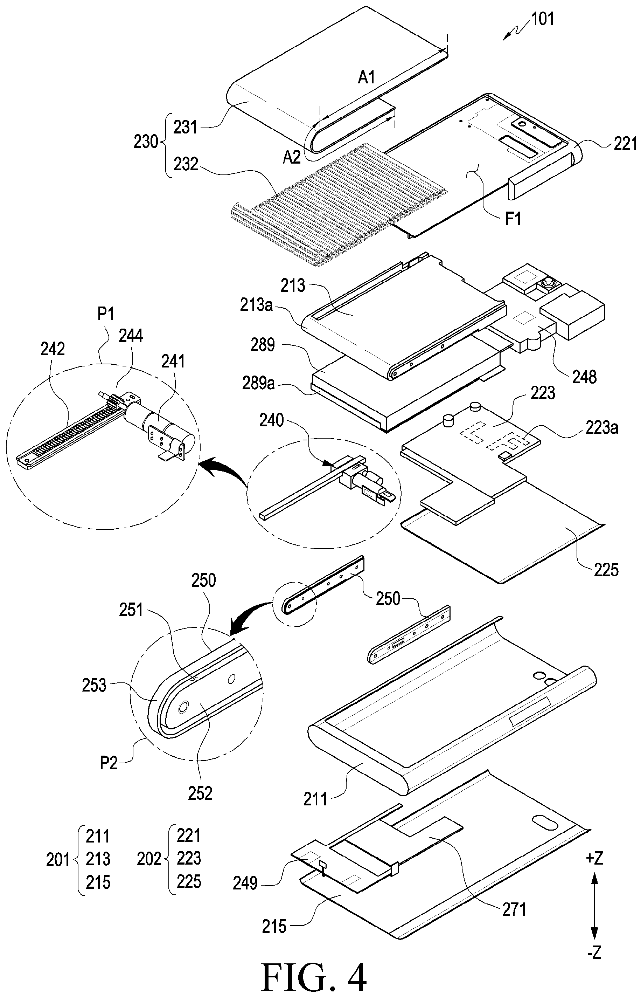

According to an embodiment, the 1-1th sidewall 211a, 1-2th sidewall 211b, and 1-3th sidewall 211c of the first cover member 211 may be formed to have a side opening (e.g., front opening) to receive (or surround) at least a portion of the second housing part 202. For example, at least a portion of the second housing part 202 may be surrounded by the first housing part 201 and be slid in the direction parallel to the first surface (e.g., the first surface F1 of FIG. 4), e.g., arrow ① direction of FIG. 3, while being guided by the first housing part 201. According to an embodiment, the 1-1th sidewall 211a, the 1-2th sidewall 211b, and/or the 1-3th sidewall 211c of the first cover member 211 may be integrally formed. According to an embodiment, the 1-1th sidewall 211a, the 1-2th sidewall 211b, and/or the 1-3th sidewall 211c of the first cover member 211 may be formed as separate structures and be combined or assembled.

According to an embodiment, the first cover member 211 may be formed to surround at least a portion of the display 203. For example, at least a portion of the display 203 may be formed to be surrounded by the 1-1th sidewall 211a, the 1-2th sidewall 211b, and/or the 1-3th sidewall 211c of the first cover member 211.

According to an embodiment, the second housing part 202 may include a second cover member 221 (e.g., a slide plate). The second cover member 221 may have a plate shape and include a first surface (e.g., the first surface F1 of FIG. 4) supporting internal components. For example, the second cover member 221 may support at least a portion of the display 203 (e.g., the first display area A1). According to an embodiment, the second cover member 221 may be referred to as a front cover.

According to an embodiment, the second cover member 221 may include a 2-1th sidewall 221a, a 2-2th sidewall 221b extending from the 2-1th sidewall 221a, and a 2-3th sidewall 221c extending from the 2-1th sidewall 221a and substantially parallel to the 2-2th sidewall 221b. According to an embodiment, the 2-2th sidewall 221b and the 2-3th sidewall 221c may be formed substantially perpendicular to the 2-1th sidewall 221a.

According to an embodiment, as the second housing part 202 moves in a first direction (e.g., the arrow ① direction of FIG. 3) parallel to the 2-2th sidewall 221b or the 2-3th sidewall 221c, the slide-in state and slide-out state of the electronic device 101 may be formed. In the slide-in state of the electronic device 101, the second housing part 202 (e.g., the 2-1th sidewall 221a) may be positioned at a first distance from the 1-1th sidewall 211a of the first housing part 201. In the slide-out state of the electronic device 101, the second housing part 202 (e.g., the 2-1th sidewall 221a) may move to be positioned at a second distance larger than the first distance from the 1-1th sidewall 211a of the first housing part 201. In an embodiment, in the slide-in state of the electronic device 101, the first housing part 201 may be formed to surround at least a portion of the 2-1th sidewall 221a.

According to an embodiment, the electronic device 101 may have an intermediate state between the slide-in state (e.g., fully closed state) of FIG. 2 and the slide-out state (e.g., fully open state) of FIG. 3. The distance between the 1-1th sidewall 211a and the 2-1th sidewall 221a in the intermediate state of the electronic device 101 may be shorter than the distance between the 1-1th sidewall 211a and the 2-1th sidewall 221a of the electronic device 101 in the fully open state and be longer than the distance between the 1-1th sidewall 211a and the 2-1th sidewall 221a of the electronic device 101 in the fully closed state. According to an embodiment, as at least a portion of the display 203 slides in the intermediate state of the electronic device 101, the area visually exposed to the outside may vary. For example, in the intermediate state of the electronic device 101, the ratio of the width (length in the X direction) to the height (length in the Y direction) of the display 203 and/or the distance between the 1-1th sidewall 211a and the 2-1th sidewall 221a may be changed based on the slide of the electronic device 101.

According to an embodiment, the electronic device 101 may include a display 203, a key input device 235, a connector hole 233, audio holes 237a and 237b, and/or camera modules 239a and 239b. According to an embodiment, the electronic device 101 may further include an indicator (e.g., a light emitting diode (LED) device) and/or various sensor modules.

According to an embodiment, the display 203 may include a first display area A1 and a second display area A2 configured to be visually exposed to the outside of the electronic device 101 based on the slide of the second housing part 202. According to an embodiment, the first display area A1 may be disposed on the second housing part 202. For example, the first display area A1 may be disposed on the second cover member 221 of the second housing part 202. According to an embodiment, the second display area A2 may extend from the first display area A1, and the second display area A2 may be received in the first housing part 201 or visually exposed to the outside of the electronic device 101 as the second housing part 202 slides relative to the first housing part 201. According to an embodiment, as the electronic device 101 changes from the slide-in state to slide-out state, the display 203 may extend in the lower direction (e.g., -Y direction) of the electronic device 101. For example, in the slide-out state of the electronic device 101, the second display area A2 may be visually exposed under the display 203 (e.g., in the -Y direction). According to an embodiment, as the electronic device 101 changes from the slide-in state to slide-out state, the display 203 may extend in the upper direction (e.g., +Y direction) of the electronic device 101. For example, in the slide-out state of the electronic device 101, the second display area A2 may be visually exposed above the display 203 (e.g., in the +Y direction).

According to an embodiment, the second display area A2 may be received in the space positioned inside the first housing part 201 or visually exposed to the outside of the electronic device while being substantially guided by one area (e.g., the curved surface 213a of FIG. 4) of the first housing part 201. According to an embodiment, the second display area A2 may move based on a slide of the second housing part 202 in the first direction (e.g., the arrow ① direction of FIG. 3). For example, while the second housing part 202 slides, a portion of the second display area A2 may be deformed into a curved shape in a position corresponding to the curved surface 213a of the first housing part 201.

According to an embodiment, as viewed from above the second cover member 221 (e.g., front cover), if the electronic device 101 changes from the slide-in state to slide-out state (e.g., if the second housing part 202 slides with respect to the first housing part 201 so that the distance between the 2-1th sidewall 221a of the second housing part 202 and the 1-1th sidewall 211a of the first housing part 201 increases), the second display area A2 may be gradually exposed to the outside of the first housing part 201 and, together with the first display area A1, form a substantially flat surface. According to an embodiment, the display 203 may be coupled with or disposed adjacent to a touch detection circuit, a pressure sensor capable of measuring the strength (pressure) of touches, and/or a digitizer for detecting a magnetic field-type stylus pen. According to an embodiment, irrespective of the slide-in state or slide-out state of the electronic device 101, the exposed portion of the second display area A2 may be positioned on a portion (e.g., the curved surface 213a of FIG. 4) of the first housing part, and a portion of the second display area A2 may remain in the curved shape in the position corresponding to the curved surface 213a.

According to an embodiment, the key input device 235 may be positioned in an area of the housing 210 (e.g., the first housing part 201 and/or second housing part 202). Depending on the appearance and the state of use, the electronic device 101 may be designed to omit the illustrated key input device 235 or to include additional key input device(s). According to an embodiment, the electronic device 101 may include a key input device (not shown), e.g., a home key button or a touchpad disposed around the home key button. According to an embodiment, at least a portion of the key input device 235 may be disposed on the 1-1th sidewall 211a, the 1-2th sidewall 211b, or the 1-3th sidewall 211c of the first housing part 201. According to an embodiment, at least a portion of the key input device 245 may be disposed on the 2-1th sidewall 221a, the 2-2th sidewall 221b, and/or the 2-3th sidewall 221c of the second housing part 202.

According to an embodiment, the connector hole 233 may be omitted or may receive a connector (e.g., a universal serial bus (USB) connector) for transmitting and receiving power and/or data with an external electronic device. According to an embodiment (not shown), the electronic device 101 may include a plurality of connector holes 233, and some of the plurality of connector holes 233 may function as connector holes for transmitting/receiving audio signals with an external electronic device. In the illustrated embodiment, the connector hole 233 is disposed in the second housing part 202, but is not limited thereto. For example, the connector hole 233 or a connector hole not shown may be disposed in the first housing part 201.

According to an embodiment, the audio holes 237a and 237b may include at least one speaker hole 237a or at least one microphone hole 237b. One of the speaker holes 237a may be provided as a receiver hole for voice calls, and the other may be provided as an external speaker hole. The electronic device 101 may include a microphone for obtaining sound. The microphone may obtain external sound of the electronic device 101 through the microphone hole 237b. According to an embodiment, the electronic device 101 may include a plurality of microphones to detect the direction of sound. According to an embodiment, the electronic device 101 may include an audio module in which the speaker hole 237a and the microphone hole 237b are implemented as one hole or may include a speaker without the speaker hole 237a (e.g., a piezo speaker). According to an embodiment, the speaker hole 237a and the microphone hole 237b may be positioned in the first housing part 201 and/or the second housing part 202.

According to an embodiment, the camera modules 239a and 239b may include a first camera module 239a (e.g., front camera) and/or a second camera module 239b (e.g., rear camera). According to an embodiment, the electronic device 101 may include at least one of a wide-angle camera, a telephoto camera or a macro camera. According to an embodiment, the electronic device 101 may include an infrared projector and/or an infrared receiver capable of measuring the distance to the subject. The camera modules 239a and 239b may include one or more lenses, an image sensor, and/or an image signal processor. The first camera module 239a may be disposed to face in the same direction as the display 203. For example, the first camera module 239a may be disposed in an area around the first display area A1 or overlapping the display 203. When disposed in the area overlapping the display 203, the first camera module 239a may obtain an image captured for the subject by detecting the light received through the display 203. According to an embodiment, the first camera module 239a may include an under display camera (UDC) that has a screen display area (e.g., the first display area A1) that may not be visually exposed but hidden. According to an embodiment, the second camera module 239b may capture the subject in a direction opposite to the first display area A1. According to an embodiment, the first camera module 239a and/or the second camera module 239b may be disposed on the second housing part 202. According to an embodiment, a plurality of second camera modules 239b may be formed to provide various arrays. For example, the plurality of second camera modules 239b may be arranged along a width direction (X-axis direction) that is substantially perpendicular to the sliding direction (e.g., Y-axis direction) of the electronic device 101. As another example, the plurality of second camera modules 239b may be arranged along the sliding direction (e.g., Y-axis direction) of the electronic device 101. As another example, the plurality of second camera modules 239b may be arranged along N * M rows and columns like a matrix.

According to an embodiment, the second camera module 239b is not visually exposed to the outside of the electronic device 101 in the slide-in state of the electronic device 101 and, in the slide-out state of the electronic device 101, may capture the outside of the electronic device 101. According to an embodiment, the second camera module 239b may capture the outside of the electronic device 101 in the slide-in state and/or slide-out state of the electronic device 101. For example, at least a portion (e.g., the first rear plate 215 and/or the second rear plate 225 of FIG. 4) of the housing 210 may be substantially transparent. The second camera module 239b may capture the outside of the electronic device 101 through the first rear plate 215 and/or the second rear plate 225. According to an embodiment, the second camera module 239b may be visually exposed to the outside of the electronic device 101 to capture the outside of the electronic device 101 in the slide-in state and slide-out state of the electronic device 101. For example, the first housing part 201 (e.g., the first rear plate 215 of FIG. 4) may include an opening 201a for the second camera module 239b.

According to an embodiment, an indicator (not shown) of the electronic device 101 may be disposed on the first housing part 201 or the second housing part 202, and the indicator may include a light emitting diode to provide state information about the electronic device 101 as a visual signal. The sensor module 238a or 238b of the electronic device 101 may produce an electrical signal or data value corresponding to the internal operation state or external environment state of the electronic device. The sensor module 238a or 238b may include a proximity sensor, a fingerprint sensor, and/or a biometric sensor (e.g., an iris/face recognition sensor or a heartrate monitor (HRM) sensor). According to an embodiment, the sensor module 238a or 238b may further include, e.g., at least one of a gesture sensor, a gyro sensor, an atmospheric pressure sensor, a magnetic sensor, an acceleration sensor, a grip sensor, a color sensor, an infrared (IR) sensor, a temperature sensor, a humidity sensor, or an illuminance sensor. According to an embodiment, the sensor module 238a or 238b may be disposed in the first housing part 201 and/or the second housing part 202. The sensor modules 238a and 238b may include a first sensor module 238a (e.g., proximity sensor or illuminance sensor) disposed on the front surface of the electronic device 101 and/or a second sensor module 238b (e.g., heart rate monitoring (HRM) sensor) disposed on the rear surface of the electronic device 101.

FIG. 4 is an exploded perspective view illustrating an electronic device according to an embodiment.

Referring to FIG. 4, an electronic device 101 may include a first housing part 201, a second housing part 202, a display assembly 230, and a driving structure 240. The configuration of the first housing part 201, the second housing part 202, and the display assembly 230 of FIG. 4 may be identical in whole or part to the configuration of the first housing part 201, the second housing part 202, and the display 203 of FIG. 2 and/or 3. The embodiment of FIG. 2 and/or FIG. 3 may be at least partially combined with the embodiment of FIG. 4.

According to an embodiment, the first housing part 201 may include a first cover member 211 (e.g., the first cover member 211 of FIGS. 2 and 3), a frame 213, and a first rear plate 215.

According to an embodiment, the first cover member 211 may receive at least a portion of the frame 213 and receive a component (e.g., battery 289) positioned in the frame 213. According to an embodiment, the first cover member 211 may be formed to surround at least a portion of the second housing part 202. According to an embodiment, the first cover member 211 may protect the components (e.g., the circuit board 249 (e.g., the sub circuit board) and/or the frame 213) positioned in the first housing part 201 from external impact. According to an embodiment, the circuit board 249 (e.g., the sub circuit board) for receiving the electronic component (e.g., the motor, speaker, and/or SIM socket) may be connected to the first cover member 211.

According to an embodiment, the frame 213 may be connected to the first cover member 211. For example, the frame 213 may be connected to the first cover member 211. The second housing part 202 is movable relative to the first cover member 211 and/or the frame 213. According to an embodiment, the frame 213 may receive the battery 289. For example, the frame 213 may include a recess for receiving the battery 289. The frame 213 may be connected to the battery cover 289a and, together with the battery cover 289a, may surround at least a portion of the battery 289. According to an embodiment, the frame 213 may include a curved surface 213a facing the display assembly 230.

According to an embodiment, the first rear plate 215 may substantially form at least a portion of the exterior of the first housing part 201 or the electronic device 101. For example, the first rear plate 215 may be coupled to the outer surface of the first cover member 211. According to an embodiment, the first rear plate 215 may provide a decorative effect on the exterior of the electronic device 101. The first rear plate 215 may be formed of at least one of metal, glass, synthetic resin, or ceramic.

According to an embodiment, the second housing part 202 may include a second cover member 221 (e.g., the second cover member 221 of FIGS. 2 and 3), a rear cover 223, and a second rear plate 225.

According to an embodiment, the second cover member 221 may be connected to the first housing part 201 through the guide rail 250 and, while being guided by the guide rail 250, reciprocate linearly in one direction (e.g., the direction of arrow ① in FIG. 3).

According to an embodiment, the second cover member 221 may support at least a portion of the display 203. For example, the second cover member 221 may include a first surface F1. The first display area A1 of the display 203 may be substantially positioned on the first surface F1 to maintain a flat panel shape. According to an embodiment, the second cover member 221 may be formed of a metal material and/or a non-metal (e.g., polymer) material. According to an embodiment, the circuit board 248 (e.g., the main circuit board) receiving the electronic component (e.g., the processor 120 and/or the memory 130 of FIG. 1) may be connected to the second cover member 221. According to an embodiment, the second cover member 221 may protect the components (e.g., the circuit board 248 (e.g., the main circuit board) and the rear cover 223) positioned in the second housing part 202 from external impact.

According to an embodiment, the rear cover 223 may protect a component (e.g., the circuit board 248 (e.g., the main circuit board)) positioned on the second cover member 221. For example, the rear cover 223 may be connected to the second cover member 221 and may be formed to surround at least a portion of the circuit board 248 (e.g., the main circuit board). According to an embodiment, the rear cover 223 may include an antenna pattern (e.g., at least one antenna element 223a) for communicating with an external electronic device. For example, when the rear cover 223 is formed of an injection molded product (e.g., an antenna carrier) of a dielectric material, the at least one antenna element 223a may be disposed on an outer surface (e.g., one surface facing in the -Z-axis direction). For example, the at least one antenna element 223a may include a laser direct structuring (LDS) antenna pattern formed on the outer surface of the rear cover 223. For example, the at least one antenna element 223a may be formed to be embedded when the rear cover 223 is injection-molded. For example, the at least one antenna element 223a may be configured to transmit or receive wireless signals in a designated frequency band (e.g., a legacy band) by electrically connecting with a wireless communication circuit (e.g., the wireless communication module) disposed on the first circuit board 248 (e.g., the main circuit board).

According to an embodiment, the second rear plate 225 may substantially form at least a portion of the exterior of the second housing part 202 or the electronic device 101. For example, the second rear plate 225 may be coupled to the outer surface of the second cover member 221. According to an embodiment, the second rear plate 225 may provide a decorative effect on the exterior of the electronic device 101. The second rear plate 225 may be formed of at least one of metal, glass, synthetic resin, or ceramic.

According to an embodiment, the display assembly 230 may include a display 231 (e.g., the display 203 of FIGS. 2 and/or 3) and a multi-bar structure 232 supporting the display 231. According to an embodiment, the display 231 may be referred to as a flexible display, a foldable display, and/or a rollable display. According to an embodiment, the first display area A1 of the display 231 may be supported by a rigid body. The second display area A2 may be supported by a bendable structure. For example, the first display area A1 may be supported by the first surface F1 of the second cover member 221 or a plate (not shown). The second display area A2 may be supported by the multi-bar structure 232.

According to an embodiment, the multi-bar structure 232 may be connected to or attached to at least a portion (e.g., the second display area A2) of the display 231. According to an embodiment, as the second housing part 202 slides, the multi-bar structure 232 may move with respect to the first housing part 201. In the slide-in state of the electronic device 101 (e.g., FIG. 2), the multi-bar structure 232 may be mostly received in the first housing part 201 and may be positioned between the first cover member 211 and the second cover member 221. According to an embodiment, at least a portion of the multi-bar structure 232 may move corresponding to the curved surface 213a positioned at the edge of the frame 213. According to an embodiment, the multi-bar structure 232 may be referred to as a display supporting member or supporting structure and may be in the form of one elastic plate.

According to an embodiment, the driving structure 240 may move the second housing part 202 relative to the first housing part 201. For example, the drive structure 240 may include a motor 241 configured to generate a driving force for sliding the second housing part 202 with respect to the first housing part 201. The driving structure 240 may include a gear 244 (e.g., a pinion) connected to the motor 241 and a rack 242 configured to mesh with the gear. FIG. 4 illustrates components (e.g., the motor 241, the rack 242, and the gear 244) of the driving structure 240 inverted (e.g., facing from the -Z-axis direction to the +Z-axis direction) in the circle P1.

According to an embodiment, the housing in which the rack 242 is positioned and the housing in which the motor 241 is positioned may be different. According to an embodiment, the motor 241 may be connected to the second housing part 202. The rack 242 may be connected to the first housing part 201. According to an embodiment, the motor 241 may be connected to the first housing part 201. The rack 242 may be connected to the second housing part 202.

According to an embodiment, the motor 241 may be controlled by a processor (e.g., the processor 120 of FIG. 1). For example, the processor 120 may include a motor driver driving circuit and transfer a pulse width modulation (PWM) signal for controlling the speed of the motor 241 and/or the torque of the motor 241 to the motor 241. According to an embodiment, the motor 241 may be electrically coupled to a processor (e.g., the processor 120 of FIG. 1) positioned on the circuit board (e.g., the circuit boards 248 and 249 of FIG. 4) using a flexible printed circuit board.

According to an embodiment, the second housing part 202 may receive the main circuit board. For example, in FIG. 4, the main circuit board may be indicated by reference numeral 248. According to an embodiment, the processor, the memory, and/or the interface may be mounted on the main circuit board. The processor may include one or more of, e.g., a central processing unit, an application processor, a graphic processing device, an image signal processing, a sensor hub processor, or a communication processor. According to an embodiment, the main circuit board may include a flexible printed circuit board type radio frequency cable (FRC). The main circuit board may be disposed on at least a portion of the second cover member 221 and may be electrically connected to the antenna module and/or the communication module.

According to an embodiment, the memory may include a volatile memory (e.g., the volatile memory 131 of FIG. 1) or a non-volatile memory (e.g., the non-volatile memory 132 of FIG. 1).

According to an embodiment, the interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, and/or an audio connector.

According to an embodiment, the electronic device 101 may include a sub circuit board in the first housing part 201. For example, in FIG. 4, the sub circuit board may be indicated by reference numeral 249. The sub circuit board may be electrically connected to the main circuit board via a flexible printed circuit board. The sub circuit board may be electrically connected with electronic components disposed in an end area of the electronic device 101, such as the battery 289 or a speaker and/or a sim socket, and may transfer signals and/or power. According to an embodiment, the sub circuit board may receive the antenna member 271 (e.g., a coil) or connect with the antenna member 271. The antenna member 271 may include an antenna for performing a wireless power charge (WPC) first, an antenna for performing a near-field communication (NFC) first, and/or a magnetic secure transmission (MST) antenna for performing an electronic payment first. For example, the battery 289 may receive power from an external electronic device using the antenna member 271 for wireless charging. As another example, the battery 289 may transfer power to the external electronic device using the antenna member 271 for wireless charging.

According to an embodiment, the battery 289 may be a device for supplying power to at least one component of the electronic device 101. The battery 189 may include a primary cell which is not rechargeable, a secondary cell which is rechargeable, or a fuel cell. The battery 289 may be integrally or detachably disposed inside the electronic device 101. According to an embodiment, the battery 289 may be formed of a single embedded battery or may include a plurality of removable batteries. According to various embodiments, the battery 289 may be position on the frame 213. For example, the battery 289 may be surrounded by the frame 213 and the battery cover 289a. According to an embodiment, the battery 289 may be positioned within the second housing part 202 and may be slid along with the second housing part 202.

According to an embodiment, the guide rail 250 may guide the movement of the multi-bar structure 232. For example, the multi-bar structure 232 may slide along the slit 251 formed in the guide rail 250. According to an embodiment, the guide rail 250 may be connected to the first housing part 201. For example, the guide rail 250 may be connected to the first cover member 211 and/or the frame 213. According to an embodiment, the slit 251 may be referred to as a groove or recess formed in the inner surface of the guide rail 250. FIG. 4 illustrates an enlarged guide rail 250 in the circle P2.

According to an embodiment, the guide rail 250 may provide a force to the multi-bar structure 232 based on the driving of the motor 241.

According to an embodiment, when the electronic device 101 changes from the slide-in state to the slide-out state, at least a portion of the second housing part 202 may slide to be exposed to the outside from the first housing part 201 through driving of the motor 241. For example, the gear 244 may rotate in a first rotation direction based on the driving of the motor 241. As the rack 242 is fixed on the second cover member 221 of the second housing part 202, the second housing part 202 may slide to be exposed to the outside of the first housing part 201 based on the sliding movement of the rack 242 toward the slide-out direction.

According to an embodiment, when the electronic device 101 changes from the slide-in state to the slide-out state, the inner portion 252 of the guide rail 250 may provide a force to the multi-bar structure 232. The multi-bar structure 232 receiving the force may be moved along the slit 251 of the guide rail 250, and the second housing part 202 may be slid to extend relative to the first housing part 201. At least a portion of the display assembly 230 accommodated between the first cover member 211 and the frame 213 may be extended to the front surface.

According to an embodiment, when the electronic device 101 changes from the slide-out state to the slide-in state, at least a portion of the second housing part 202 may slide to be inserted into the first housing part 201 through driving of the motor 241. For example, the gear 244 may rotate in a second rotation direction opposite to the first rotation direction based on the driving of the motor 241. As the rack 242 is fixed on the second cover member 221 of the second housing part 202, the second housing part 202 may slide to enter the first housing part 201 based on the sliding movement of the rack 242 toward the slide-in direction.

According to an embodiment, when the electronic device 101 changes from the slide-out state to the slide-in state, the outer portion 253 of the guide rail 250 may provide a force to the bent multi-bar structure 232. The multi-bar structure 232 receiving the force may be moved along the slit 251 of the guide rail 250, and at least a portion of the second housing part 202 may be slid to be received in the first housing part 201. At least a portion of the display assembly 230 may be accommodated between the first cover member 211 and the frame 213.

According to an embodiment, the electronic device 101 may be configured to stop in a designated intermediate state between the slide-in state and the slide-out state by controlling driving of the motor 241 (free stop function). According to an embodiment, the electronic device 101 may be changed to the slide-in state, the intermediate state, or the slide-out state through the user's manipulation in the state in which the driving force is not provided to the motor 241.

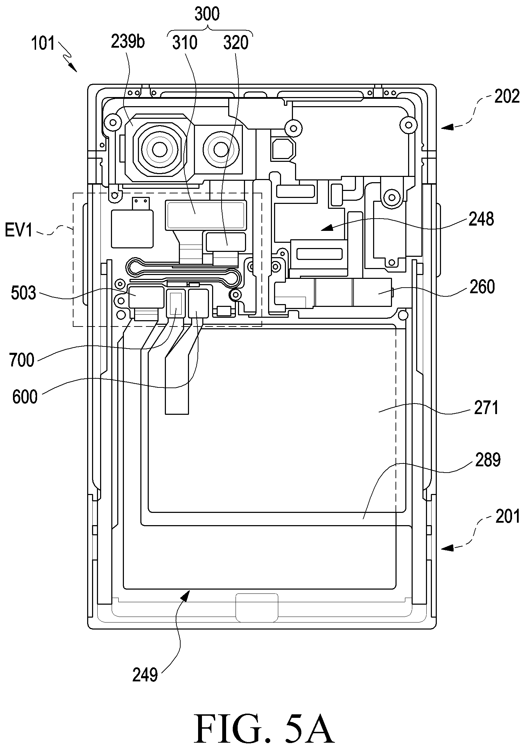

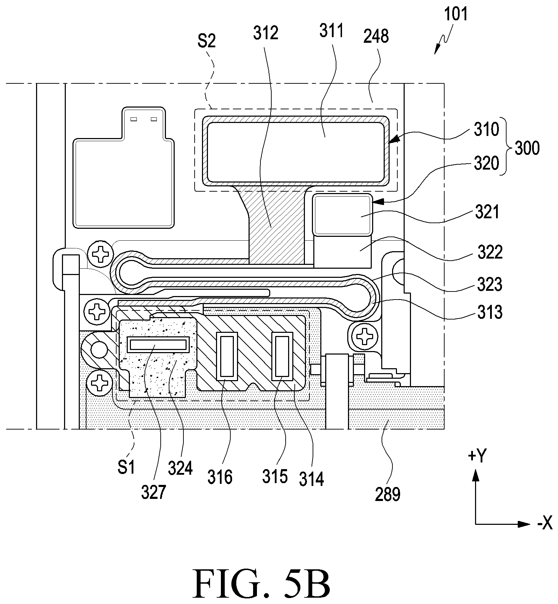

FIG. 5A is a view illustrating a portion of an electronic device according to an embodiment. FIG. 5B is an enlarged view EV1 of a flexible printed circuit board portion in FIG. 5A. It is possible to identify the relationship between the first printed circuit board, the second printed circuit board, and the flexible printed circuit board provided in the electronic device through FIGS. 5A and 5B.

When the description of one component in an embodiment is identical to the description of the component in another embodiment in describing each embodiment of the disclosure, no description is given of the duplicate content described above.

**In** the following detailed description of FIGS. 1 to 4 and 5A and 5B, the length direction of the electronic device 101 may be defined as the 'Y-axis direction', the width direction as the 'X-axis direction', and/or the height direction (the thickness direction) as the 'Z-axis direction'. In the following detailed description, the mentioned length direction, width direction, and/or height direction (or thickness direction) may indicate the length direction, the width direction, and/or the height direction (or thickness direction) of the electronic device 101. In an embodiment, 'negative/positive (-/+)' may be mentioned together with the Cartesian coordinate system exemplified in the drawings with respect to the direction in which the component is oriented. For example, the front surface of the electronic device 101 may be defined as a 'surface facing in the +Z-axis direction,' and the rear surface may be defined as a 'surface facing in the -Z-axis direction'. According to an embodiment, the arrangement relationship in the length direction of a component or another component, that is, the reference as to whether a component is on/under another component, may follow the +Y-axis direction/-Y-axis direction. In other words, when a component is disposed on another component, it may mean that the component is disposed on the +Y-axis direction with respect to the other component, and when a component is disposed under another component, it may mean that the component is disposed on the -Y-axis direction with respect to the other component. According to an embodiment, the arrangement relationship in the height direction (or thickness direction) of a component or another component, that is, the reference as to whether a component is before/after (or in front of/behind) another component, may follow the +Z-axis direction/-Z-axis direction. In other words, when a component is disposed in front of another component, it may mean that the component is disposed on the +Z-axis direction with respect to the other component, and when a component is disposed behind another component, it may mean that the component is disposed on the -Z-axis direction with respect to the other component. Meanwhile, it should be noted that although a component is disposed on or under (in front of or behind) another component, it does not necessarily mean that the entire component is disposed on or under (in front of or behind) the entire other component. For example, it should be noted that a portion of the component may be disposed on (in front of) a portion of the other component while another portion of the component may be disposed under (behind) another portion of the other component. In the following description, it should be noted that when a component overlaps (or is stacked on) another component, the above description of the arrangement relationship in height direction (thickness direction) may apply. According to an embodiment, in the describing of the components, when a component is viewed from 'above,' it may indicate that the component is viewed in the Z-axis direction and, when a component is viewed from a 'side surface,' it may indicate that the component is viewed in the Y-axis direction. In describing the direction, when 'negative/positive (-/+)' is not shown, it may be interpreted as facing in the + direction unless separately defined. For example, the 'Z-axis direction' may be interpreted as facing in the +Z direction, and the 'X-axis direction' and the 'Y-axis direction' may be interpreted as facing in the +X-axis direction and the +Y-axis direction, respectively. In describing the direction, facing in any one of the three axes of the orthogonal coordinate system may include facing in a direction parallel to the axis. For simplicity of description, this is based on the Cartesian coordinate system illustrated in the drawings, and it should be noted that descriptions of such directions or components do not limit various embodiments of the disclosure.

The second housing part 202 may be disposed to be movable from the first housing part 201. The second housing part 202 may be drawn into the first housing part 201 as shown in FIG. 5A. According to an embodiment, the main circuit board, the camera module (e.g., the second camera module 239b), and other components (e.g., the actuator 260) may move together with the second housing part 202. For example, the main circuit board may be a portion denoted by reference numeral 248 in FIG. 5A, but is not limited thereto.

According to an embodiment, when the state of FIG. 2 is changed to the state of FIG. 3, the second housing part 202 and components (main circuit board, camera module (e.g., second camera module 239b), and other components (e.g., actuator 260) disposed inside the second housing part 202 may move in one direction (e.g., +Y direction). Conversely, when the state of FIG. 3 is changed to the state of FIG. 2, the second housing part 202 and components (main circuit board, camera module (e.g., second camera module 239b), and other components (e.g., actuator 260) disposed inside the second housing part 202 may move in the opposite direction (e.g., -Y direction).

The electronic device 101 may include circuit boards (e.g., 248 or 249). The circuit board may be provided as a component for disposing various components (e.g., a processor or memory) and/or a connector for connecting various components, inside the electronic device 101. In the case of a slidable electronic device (e.g., the electronic device 101 of FIGS. 2 to 5B), e.g., a 'circuit board' may be provided for arranging, e.g., a processor (e.g., an AP or a CP), a driving structure including a motor or a gear, and/or accompanying electronic components and electrically connecting the same.

In the disclosure, the 'circuit board' may be referred to as a board or a substrate, or may be referred to as a printed circuit board. It should be noted that in the following description and/or claims, if a component is referred to by one of the terms 'circuit board, substrate, and printed circuit board', the component may be referred to or substituted by another term.

In the disclosure, the 'circuit board' may be classified according to the position to be disposed and/or the type of the component mounted thereon. For example, as described above with reference to FIGS. 2 to 4, the electronic device 101 may include, as the circuit board, a main circuit board and a sub circuit board disposed to be spaced apart from the main circuit board by a predetermined distance. For example, the electronic device 101 may include a main circuit board positioned above a virtual line passing through the center of the electronic device 101 along the width direction of the electronic device 101 and a sub circuit board therebelow. For example, in FIG. 5A, the main circuit board may be a portion indicated by reference numeral 248, and the sub circuit board may be a portion indicated by reference numeral 249. Referring to FIG. 5A, the sub circuit board may be positioned on the rear surface of the battery 289 or under the battery 289. However, the position of the main circuit board and the position of the sub circuit board are not necessarily limited thereto, and unlike those illustrated in the drawings, an embodiment in which the sub circuit board is positioned at an upper portion of the electronic device 101 and the main circuit board is positioned at a lower portion of the electronic device 101 may also be applied.

In the disclosure, the 'circuit board' may include a printed circuit board (PCB) and a flexible printed circuit board (FPCB) according to its properties (e.g., whether deformable and/or material). For example, the flexible printed circuit board FPCB is a circuit board formed to be at least partially bendable, and may be distinguished from the printed circuit board PCB in the form of a hard solid plate. The hard solid plate printed circuit board (PCB) may be referred to as a rigid printed circuit board (RPCB) or a non-flexible printed circuit board (RPCB), but according to an embodiment, the modifier "rigid" may be omitted and briefly referred to as a printed circuit board (PCB). If the term 'flexible' is not mentioned together on the circuit board in the following description and/or claims, the circuit board may be understood as a printed circuit board (PCB) which is entirely formed of a hard material. In the following description and claims, when a plurality of circuit boards are mentioned together, e.g., if a "circuit board A" is denoted as a printed circuit board (PCB), and another "circuit board B" is denoted as a flexible printed circuit board (FPCB), this may be understood to intentionally distinguish the properties of the "circuit board A" and the "circuit board B" in which case the circuit board A may be understood as meaning a rigid printed circuit board. Whether a certain circuit board corresponds to a printed circuit board (PCB) or a flexible printed circuit board (FPCB) may vary depending on, e.g., the dependency in the following description or claims. For example, although a "circuit board C" is a component denoted as a printed circuit board (PCB) in a claim (e.g., claim 1), if a dependent claim (e.g., claim 2 depending on claim 1) separately defines it as a flexible printed circuit board (FPCB), the "circuit board C" may be understood as a flexible printed circuit board (FPCB).

Referring to FIGS. 5A and 5B, the electronic device 101 of the disclosure may include a flexible printed circuit board according to another embodiment. In FIGS. 5A and 5B, the flexible printed circuit board may be a portion indicated by reference numeral 300. The flexible printed circuit board is a component that at least partially includes a flexible portion and may be provided separately from the main circuit board and the sub circuit board. According to an embodiment, the flexible printed circuit board may be provided to electrically connect the main circuit board and the sub circuit board. The flexible printed circuit board may be configured to electrically connect the main circuit board and the sub circuit board to each other even if the distance between the main circuit board and the sub circuit board increases or decreases when the first housing part 201 of the electronic device 101 slides with respect to the second housing part 202. Accordingly, the flexible printed circuit board, although deforming, may stably transfer signals from the main circuit board to the sub circuit board or from the sub circuit board to the main circuit board.

Hereinafter, in the description or claims to be described below, when a plurality of circuit boards are mentioned together, each of the plurality of circuit boards may be distinguished using an ordinal number. The ordinal number is used to distinguish the corresponding component from other corresponding components, and the corresponding components are not limited in other aspects (e.g., importance or order).

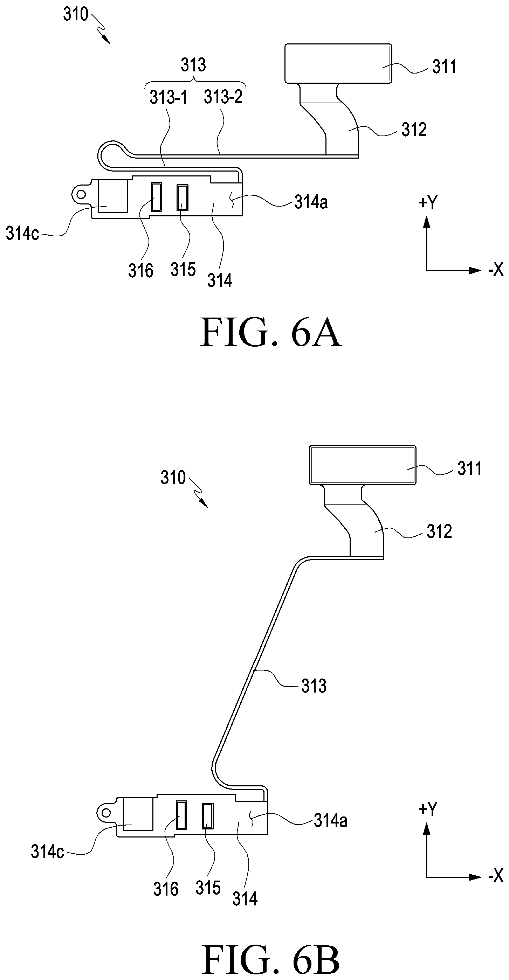

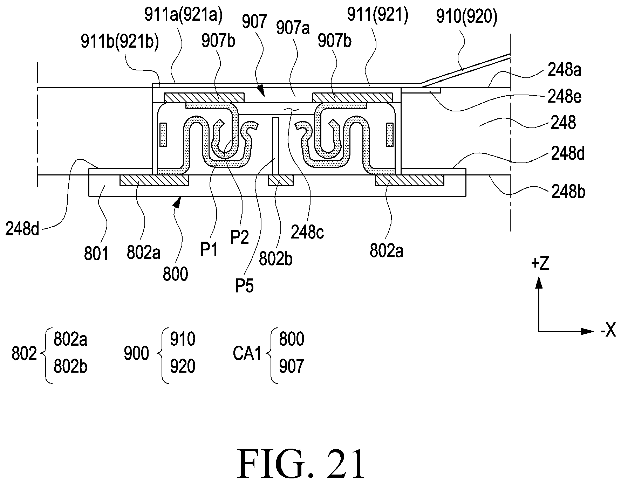

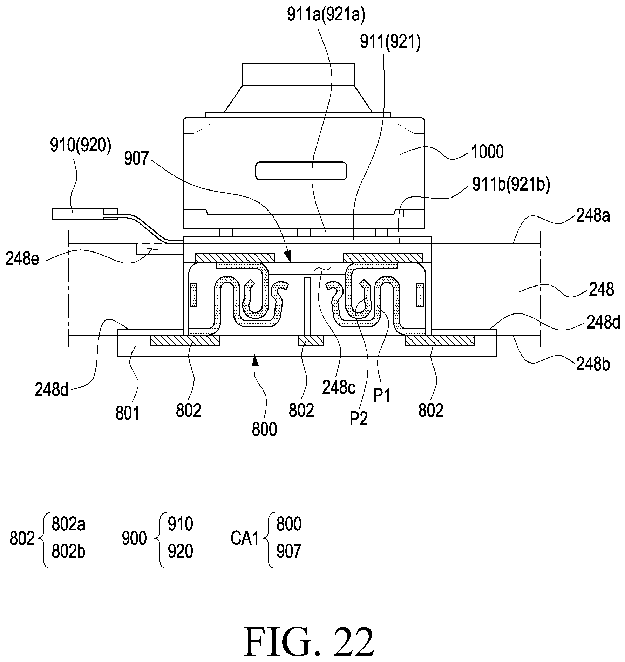

As another example, hereinafter, according to the embodiments of FIGS. 21 and 22, the main circuit board included in the electronic device 101 may be denoted as a 'first printed circuit board (first PCB) 248', and the flexible printed circuit board for electrically connecting the main circuit board and the sub circuit board may be denoted as a 'second printed circuit board (second PCB) 900'. In the embodiments of FIGS. 21 and 22, the main circuit board may be changed to the sub circuit board and applied. As another example, according to the embodiments of FIGS. 6A to 14C, one flexible printed circuit board for electrically connecting the main circuit board and the sub circuit board may be referred to as a 'first printed circuit board 300', and the other flexible printed circuit board may be referred to as a 'second printed circuit board 500'.

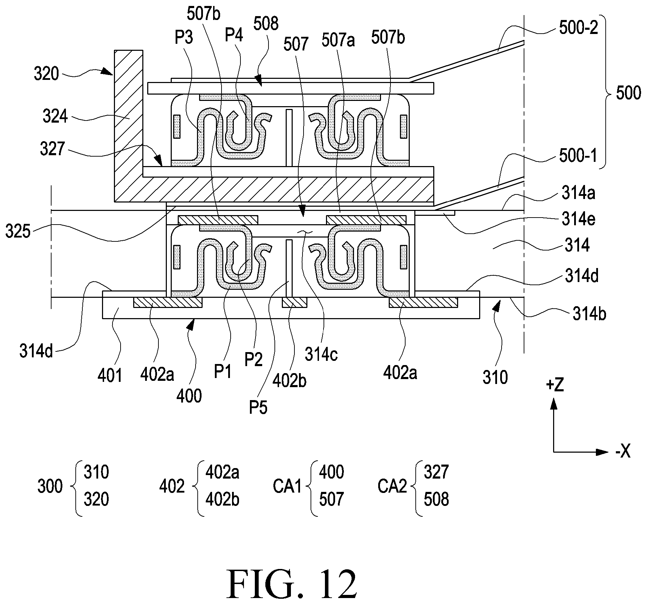

In other words, referring to FIG. 5B, the disclosure may include, as two different aspects, an embodiment (e.g., hereinafter, the embodiment of FIGS. 6A to 14C) in which the flexible printed circuit board corresponds to the "first printed circuit board 300" and an embodiment (e.g., hereinafter, the embodiment of FIGS. 21 and 22) in which the rigid printed circuit board such as the main circuit board corresponds to the "first printed circuit board 248". For example, the embodiment (e.g., the embodiment of FIGS. 6A to 14C) in which the flexible printed circuit board corresponds to the first printed circuit board 300 may be mentioned when describing an arrangement structure (e.g., the embodiment of FIG. 12 as a representative example) of a connector focusing on section S1 of FIG. 5B. Further, e.g., the embodiment in which the rigid printed circuit board corresponds to the first printed circuit board 248 may be mentioned when describing an arrangement structure (e.g., the embodiment of FIG. 21 as a representative example) of a connector focusing on section S2 of FIG. 5B.

First, referring to FIGS. 6A to 7B, the electrical connection and/or arrangement relationship between components may be described in detail, focusing on the embodiment in which the flexible printed circuit board is denoted as the 'first printed circuit board 300'.

In the disclosure, when one component is 'connected' to another component, it may include a physical connection or an electrical connection, and may include a direct connection between the two, as well as an indirect connection in which another component is used as a medium. Therefore, when a component is 'connected' to another component in the disclosure, the various connection methods or combinations thereof may be variously applied according to embodiments unless defined separately. For example, referring to FIG. 5B, the first printed circuit board 300 may be connected to the main circuit board. According to an embodiment, the first printed circuit board 300 may not be directly connected to the sub circuit board, but may be indirectly connected through the second printed circuit board 500 to be described below.

The first printed circuit board 300 may include a plurality of lines. Further, the plurality of lines may be functionally divided. Here, the line may be a signal line through which at least one signal passes or a power line for power transmission, and may be denoted as a conductive pattern or a conductor line. For example, The first printed circuit board 300 may include lines for transferring a plurality of signals having different signal characteristics. For example, the first printed circuit board 300 may include a first line having a first signal characteristic and a second line having a second signal characteristic different from the first signal characteristic. For example, the first line and/or the second line may be power line, logic line, and/or radio frequency (RF) line. Here, the power line is a line for power connection between the battery 289 and the main circuit board, and may transfer VBAT power and ground (GND) signals. The RF line is a line for RF communication and may transfer transmission (Tx) signals and/or reception (Rx) signals of various bands (e.g., low band, mid band, and/or high band). The logic line may transfer audio signals (e.g., signals related to microphone and/or speaker operations), data measured by various sensors (e.g., various sensors such as a grip sensor or a temperature sensor), and/or mobile industry processor interface (MIPI) signals related to sensor operations, and/or clock (CLK) signals for controlling the operation of a component performing at least one function. When a certain line is formed to be longer than a designated length or is bent, or other electronic components or other lines are disposed therearound, loss may be increased by the signal characteristics, and a timing delay may occur or, due to noise such as electromagnetic interference (EMI), the performance of the device connected with the line (e.g., the performance of the antenna device) may deteriorate. For example, the RF line may be vulnerable to noise. Accordingly, according to the disclosure, when the first printed circuit board 300 includes lines having different signal characteristics, it is possible to provide a division structure for separating some lines from other lines. The division structure of the first printed circuit board 300 may be an appropriate response to the trend of increasing lines to the electronic device 101 as well as the purpose of reducing noise signals for RF line.

According to an embodiment, the first printed circuit board 300 may include a 1-1th flexible printed circuit board 310 as the division structure. Further, the first printed circuit board 300 may include a 1-2th flexible printed circuit board 320 as the division structure. According to an embodiment, one first printed circuit board 300 may be divided into the 1-1th flexible printed circuit boards 310 and 1-2th flexible printed circuit boards 320 which are different from each other. In this case, the line included in the 1-1th flexible printed circuit board 310 may have signal characteristics different from those included in the 1-2th flexible printed circuit board 320. For example, the 1-1th flexible printed circuit board 310 may include a power line, and the 1-2th flexible printed circuit board 320 may include an RF line. However, without limitations thereto, lines disposed on the 1-1th flexible printed circuit board 310 and the 1-2th flexible printed circuit board 320 may add, or be replaced with, other lines. Hereinafter, for convenience of description, the following description focuses primarily on an embodiment in which the 1-1th flexible printed circuit board 310 includes a power line, an MFC line, and a logic line, and the 1-2th flexible printed circuit board 320 includes an RF line.

Both the 1-1th flexible printed circuit board 310 and the 1-2th flexible printed circuit board 320 may include a flexible portion which is bendable and a rigid portion that is not bendable. According to an embodiment, the 1-1th flexible printed circuit board 310 may include a first rigid portion 311 and a second rigid portion 314 at one end and the other end, respectively, and may include flexible portions 312 and 313 disposed between the first rigid portion 311 and the second rigid portion 314. According to another embodiment, the 1-2th flexible printed circuit board 320 may include a third rigid portion 321 and a fourth rigid portion 324 at one end and the other end, respectively, and may include flexible portions 322 and 323 disposed between the third rigid portion 321 and the fourth rigid portion 324.

According to an embodiment, the first rigid portion 311 and the third rigid portion 321 each may be connected to the main circuit board, and may be disposed to overlap the main circuit board. In this case, the first rigid portion 311 and the third rigid portion 321 may be disposed adjacent to each other. The first rigid portion 311 and the third rigid portion 321 may be directly connected to the main circuit board. The second rigid portion 314 and the fourth rigid portion 324 may be disposed at positions spaced apart from the main circuit board by a predetermined distance. In this case, the second rigid portion 314 may be disposed adjacent to the fourth rigid portion 324. According to an embodiment, the fourth rigid portion 324 may partially overlap the second rigid portion 314. Meanwhile, here, the first rigid portion 311, the second rigid portion 314, the third rigid portion 321, and the fourth rigid portion 324 may be components that have a relatively higher strength than the flexible portions 312, 313, 322, and 323 to reduce and/or prevent physical deformation. Therefore, it should be noted that the first rigid portion 311, the second rigid portion 314, the third rigid portion 321, and the fourth rigid portion 324 do not necessarily have to be formed of a material that is not bent, but may be formed of a material that may be bent with a predetermined curvature according to embodiments.

At least one connector may be disposed on the first rigid portion 311 and the third rigid portion 321. Further, at least one connector may be disposed on the second rigid portion 314 and the fourth rigid portion 324. Each of the first rigid portion 311, the second rigid portion 314, the third rigid portion 321, and the fourth rigid portion 324 may include a first surface facing in one direction and a second surface facing in a direction opposite to the one direction, and at least one connector may be disposed on at least one of the first surface and the second surface. For example, FIG. 5B illustrates a state in which at least one connector 315 and 316 is disposed on the first surface 314a of the second rigid portion 314, and at least one connector 327 is disposed on the first surface of the fourth rigid portion 324. According to an embodiment, a plurality of connectors may be disposed on at least one surface of the first rigid portion 311, the second rigid portion 314, the third rigid portion 321, and the fourth rigid portion 324. For example, a plurality of connectors 315 and 316 may be disposed on the second rigid portion 314 of FIG. 5B. The plurality of connectors 315 and 316 may be, e.g., a connector for power signal transmission and a connector for wireless communication (e.g., WPC, NFC, and/or MST), and the connector disposed on the fourth rigid portion 324 may be, e.g., a connector for RF signal transmission. Although not shown in the drawings, at least one connector may be disposed on the first rigid portion 311 and the third rigid portion 321 to be connected to a connector disposed on the main circuit board. However, it should be noted that this is merely an example for convenience of description and is not necessarily limited thereto. According to an embodiment, at least some of the connector(s) disposed on the second rigid portion 314 and/or the fourth rigid portion 324 may be connected to the second printed circuit board 500 to be described below. An embodiment in which at least one connector is disposed on the first rigid portion 311 (or the second rigid portion 321) is described below in the embodiment of FIG. 21 or subsequent figures.

FIG. 6A is a view illustrating a state of a 1-1th flexible printed circuit board corresponding to a slide-in state of an electronic device according to an embodiment. FIG. 6B is a view illustrating a state of a 1-1th flexible printed circuit board corresponding to a slide-out state of an electronic device according to an embodiment.

Referring to FIGS. 6A and 6B, a 1-1th flexible printed circuit board 310 may include a first rigid portion 311 at one end, a second rigid portion 314 at the other end, and flexible portions 312 and 313 disposed between the first rigid portion 311 and the second rigid portion 314. The first rigid portion 311 and the second rigid portion 314 may be rigid portions relatively harder than the flexible portions 312 and 313. The first rigid portion 311 and the second rigid portion 314 may be substantially parallel to the front surface of the electronic device 101. According to an embodiment, the flexible portions 312 and 313 may include a first flexible portion 312 extending from the first rigid portion 311, substantially parallel to the first rigid portion 311 and the second rigid portion 314. According to another embodiment, the flexible portions 312 and 313 may include a second flexible portion 313 facing in a direction substantially perpendicular to the first rigid portion 311 and the second rigid portion 314, in addition to, or instead of, the first flexible portion 312. Here, when a component is 'substantially parallel to' another component, it may include a difference in angle between the direction in which the component faces and the direction in which the other component faces being 0 degrees, and may include having a difference in angle in a range within up to ±45 degrees with respect to 0 degrees. Further, when a component is 'substantially perpendicular to' another component, it may include a difference in angle between the direction in which the component faces and the direction in which the other component faces being 90 degrees, and may include having a difference in angle in a range of at least one ±45 degrees or more with respect to 0 degrees.

The second flexible portion 313 may be deformed in response to a slide-in or slide-out operation of the electronic device. According to an embodiment, the second flexible portion 313 may be partially folded in the slide-in state of the electronic device. In this case, at least one portion of the 2-1th flexible portion 313-1 included in the second flexible portion 313 and at least one portion of the 2-2th flexible portion 313-2 included in the second flexible portion 313 may face each other. In contrast, in the slide-out state of the electronic device, the second flexible portion 313 may be unfolded. However, this is merely an example, and examples of the flexible portions 312 and 313 of the disclosure are not necessarily limited to the above-described embodiments. If the flexible portions 312 and 313 are formed to be extended and contracted up and down along the length direction of the electronic device, a shape different from that shown in FIG. 5 may also be applicable. As the 1-1th flexible printed circuit board 310 includes the flexible portions 312 and 313, signal transmission via the main circuit board may be smoothly performed even when the gap between the first rigid portion 311 and the second rigid portion 314 is changed according to the slide-in or slide-out operation of the electronic device 101.

The first printed circuit board 300 may include an opening 314c. According to an embodiment, the opening 314c may be formed in one surface 314a of the second rigid portion 314 of the 1-1th flexible printed circuit board 310. A plurality of connectors may be disposed on the second rigid portion 314 of the 1-1th flexible printed circuit board 310. According to the disclosure, a contact point for one of the plurality of connectors may be formed in the opening 314c.

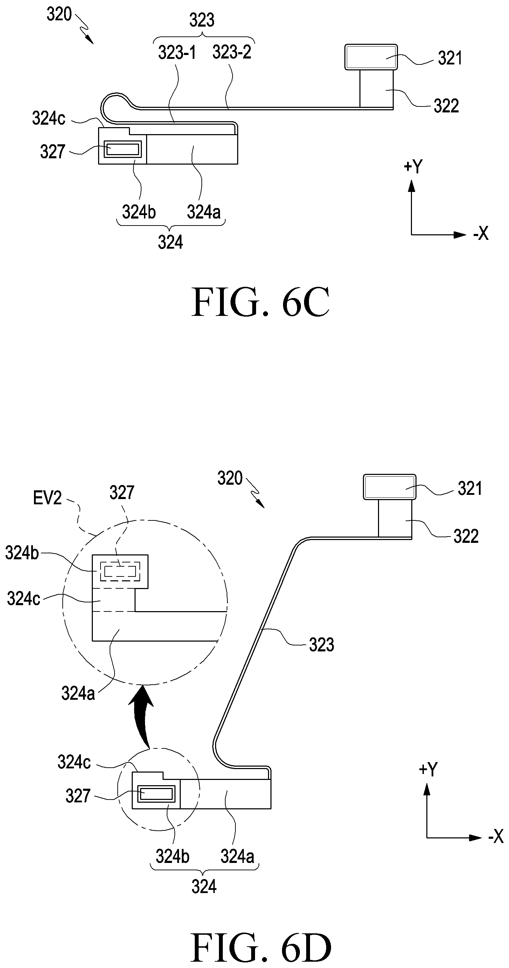

FIG. 6C is a view illustrating a state of a 1-2th flexible printed circuit board corresponding to a slide-in state of an electronic device according to an embodiment. FIG. 6D is a view illustrating a state of a 1-2th flexible printed circuit board corresponding to a slide-out state of an electronic device according to an embodiment.

Referring to FIGS. 6C and 6D, a 1-2th flexible printed circuit board 320 may include a third rigid portion 321 at one end, a fourth rigid portion 324 at the other end, and flexible portions 322 and 323 disposed between the third rigid portion 321 and the fourth rigid portion 324. The third rigid portion 321 and the fourth rigid portion 324 may be rigid portions harder than the flexible portions 322 and 323. The third portion 321 and the fourth rigid portion 324 may be substantially parallel to the front surface of the electronic device 101. According to an embodiment, the flexible portions 322 and 323 may include a third flexible portion 322 substantially parallel to the third rigid portion 321 and the fourth rigid portion 324. According to another embodiment, the flexible portions 322 and 323 may include a fourth flexible portion 323 facing in a direction substantially perpendicular to the third rigid portion 321 and the fourth rigid portion 324, in addition to, or instead of, the third flexible portion 322.

According to an embodiment, the second flexible portion 323 may be partially folded in the slide-in state of the electronic device. In this case, at least one portion of the 4-1th flexible portion 323-1 included in the fourth flexible portion 323 and at least one portion of the 4-2th flexible portion 323-4 included in the fourth flexible portion 323 may face each other. In contrast, in the slide-out state of the electronic device, the fourth flexible portion 323 may be unfolded. Further, the description of the flexible portions 312 and 313 of FIGS. 6A and 6B may apply to the description of the flexible portions 322 and 323 of FIGS. 6C and 6D.

According to an embodiment, the fourth rigid portion 324 of the 1-2th flexible printed circuit board 320 may include a 4-1th rigid portion 324a and a 4-2th rigid portion 324b disposed on a plane different from that of the 4-1th rigid portion 324a. Here, the 'plane' may mean, e.g., a virtual plane parallel to the XY plane formed by the X-axis (e.g., the -X-axis) and the Y-axis (e.g., the +Y-axis) of FIGS. 6C and 6D. Accordingly, when the 4-2th rigid portion 324b is disposed on the plane different from that of the 4-1th rigid portion 324a, it may mean that the 4-2th rigid portion 324b is spaced apart from the 4-1th rigid portion 324a in the height direction (or thickness direction) (e.g., the Z-axis direction of FIG. 4) of the electronic device.

FIGS. 6C and 6D may illustrate that the 4-1th rigid portion 324a and the 4-2th rigid portion 324b are disposed on different planes, and when the first surface 314a of the second rigid portion 314 is viewed from above, they overlap each other so that a portion of the 4-1th rigid portion 324a is covered. A bending portion 324c may be disposed between the 4-1th rigid portion 324a and the 4-2th rigid portion 324b. In FIG. 6D, the enlarged view EV2 of the 4-1th rigid portion 324a and the 4-2th rigid portion 324b shows the 4-1th rigid portion 324a and the 4-2th rigid portion 324b of the fourth rigid portion 324 folded around the bending portion 324c and the bending portion 324c are unfolded on substantially the same plane. When the fourth rigid portion 324 shown in the enlarged view EV2 of FIG. 6D is folded around the bending portion 324c, the 4-2th rigid portion 324b may be disposed on a plane different from that of the 4-1th rigid portion 324a.

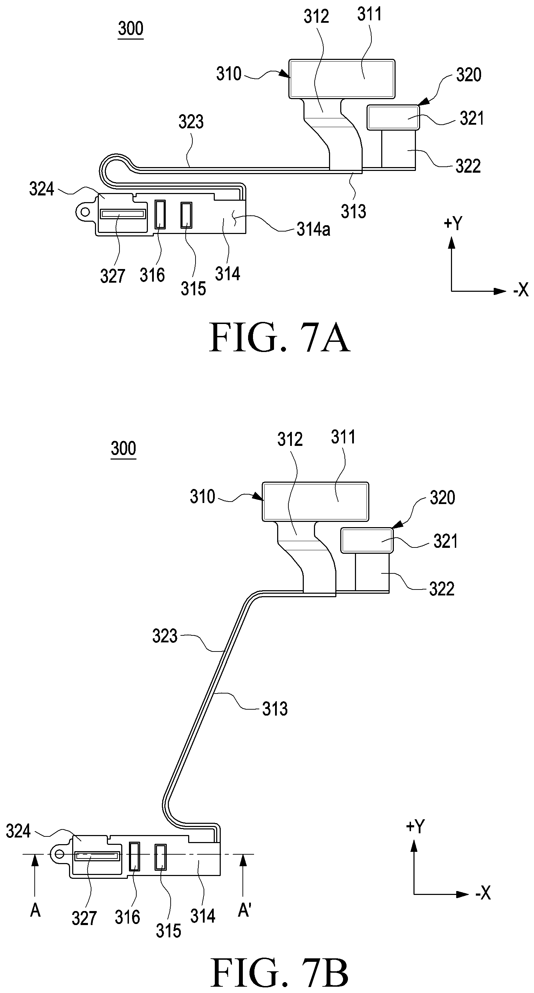

FIG. 7A is a view illustrating a state of a 1-1th flexible printed circuit board and a 1-2th flexible printed circuit board connected to each other in a slide-in state of an electronic device according to an embodiment. FIG. 7B is a view illustrating a state of a 1-1th flexible printed circuit board and a 1-2th flexible printed circuit board connected to each other in a slide-out state of an electronic device according to an embodiment.

FIGS. 7A and 7B may illustrate a behavior according to a slide-in and slide-out state of the electronic device 101 in a state in which the 1-1th flexible printed circuit board 310 and the 1-2th flexible printed circuit board 320 are disposed adjacent to each other.

According to an embodiment, the 1-2th flexible printed circuit board 320 may partially overlap the 1-1th flexible printed circuit board 310. For example, the fourth rigid portion 324 of the 1-2th flexible printed circuit board 320 may overlap the second rigid portion 314 of the 1-1th flexible printed circuit board 310 in the front/rear in the height direction (or thickness direction) (e.g., the Z-axis direction of FIG. 4) of the electronic device. Further, the flexible portion 323 of the 1-2th flexible printed circuit board 320 may overlap the flexible portion 313 of the 1-1th flexible printed circuit board 310 up/down in the length direction of the electronic device. When the second rigid portion 314 and the fourth rigid portion 324 are disposed to overlap each other, the 4-1th rigid portion 324a may face the second surface (e.g., the second surface 314b of FIG. 12) of the second rigid portion 314. The 4-2th rigid portion 324b may extend from one end of the 4-1th rigid portion 324a using the bending portion 324c and may be positioned on substantially the same plane as the first surface 314a of the second rigid portion 314. The 4-1th rigid portion 324a is a portion overlapping the second rigid portion 314, e.g., and may be disposed on a rear surface of the second rigid portion 314. The rear surface of the second rigid portion 314 may be the surface opposite to the surface on which at least one connector 315 and 316 is disposed. The 4-2th rigid portion 324b may be a component positioned in front of the 4-1th rigid portion 324a. According to an embodiment, a connector 327 may be disposed on the 4-2ndth rigid portion 324b. According to an embodiment, the 4-2th rigid portion 324b may be disposed at a position overlapping the opening 314c of the second rigid portion 314. According to an embodiment, the 4-2th rigid portion 324b may be disposed to overlap the connector disposed on the 4-1th rigid portion 324a.

According to an embodiment, at least a portion of the 1-1th flexible printed circuit board 310 and at least a portion of the 1-2th flexible printed circuit board 320 may be connected to each other. Here, the 'connection' may include a physical or chemical connection, and may include all of various types of connections such as bonding, fastening, bonding, attaching, and contacting. Referring to FIGS. 7A and 7B, if the 1-1th flexible printed circuit board 310 moves according to the slide-in state of the electronic device 101 or the slide-out state of the electronic device 101 in a state in which at least a portion of the 1-1th flexible printed circuit board 310 and at least a portion of the 1-2th flexible printed circuit board 320 are connected to each other, the 1-2th flexible printed circuit board 320 may also move.

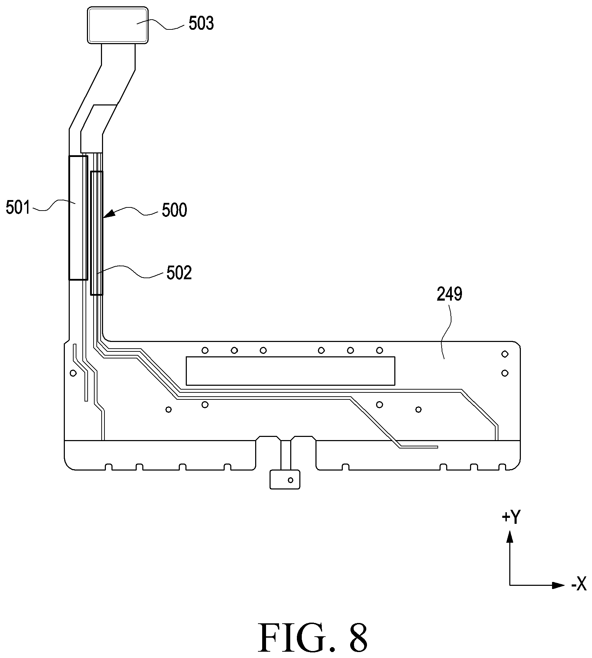

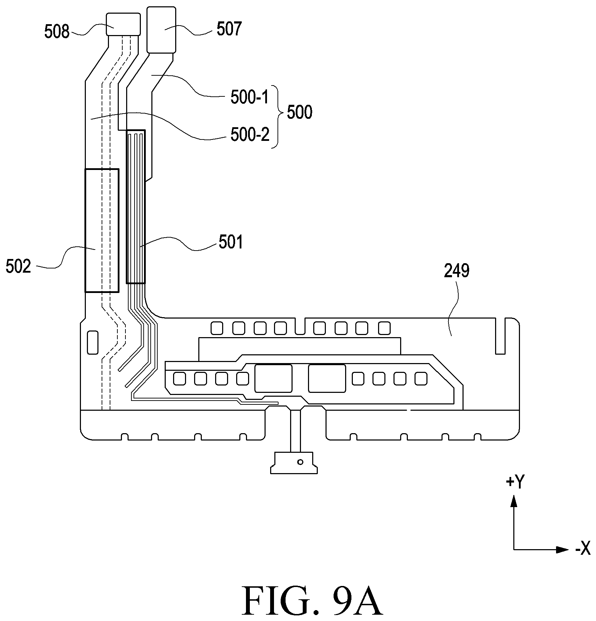

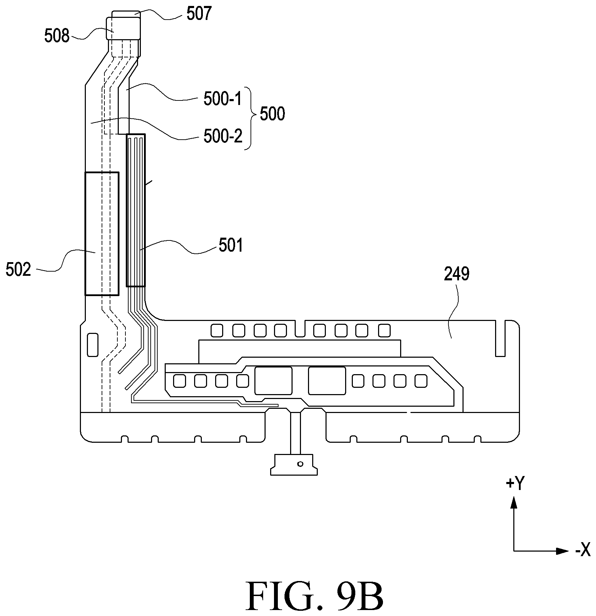

Hereinafter, the second printed circuit board is described in detail with reference to the embodiments of FIGS. 8 and 9. In the embodiments of FIGS. 8 and 9, the description may focus on an embodiment in which a flexible printed circuit board provided separately from the first printed circuit board 300 corresponds to the 'second printed circuit board 500.'

FIG. 8 is a view illustrating a sub circuit board and a second printed circuit board according to an embodiment. FIG. 9A is a view illustrating a sub circuit board and a second printed circuit board according to an embodiment.

The electronic device 101 may include a second printed circuit board 500. The second printed circuit board 500 may include a flexible printed circuit board (FPCB). According to an embodiment, the second printed circuit board 500 may be connected to the sub circuit board. For example, the second printed circuit board 500 may be integrally formed with the sub circuit board. The second printed circuit board 500 may extend long along the length direction of the electronic device 101 from the sub circuit board and may be electrically connected to the first printed circuit board 300 in section S2 of FIG. 5. The second printed circuit board 500 may extend from the sub circuit board toward the main circuit board, and the second printed circuit board 500 may be electrically connected to the main circuit board via the first printed circuit board 300.

Referring to FIG. 8, the second printed circuit board 500 may include lines 501 and 502 having different signal characteristics. For example, the second printed circuit board 500 may include a third line 501 having a third signal characteristic and a fourth line 502 having a fourth signal characteristic. For example, The third line 501 may include a logic line, and the fourth line 502 may include an RF line. However, it should be noted that this is merely an example for convenience of description, and the type and arrangement of lines of the disclosure are not necessarily limited thereto.

According to an embodiment, the third line 501 and the fourth line 502 may be connected to the first printed circuit board 300 using one integrated connector 503.

However, in the embodiment of FIG. 8, as another line (third line 501) (e.g., a logic line) is disposed very adjacent to the fourth line 502 (e.g., an RF line), a noise signal may easily be induced in the fourth line 502. Accordingly, according to an embodiment of the disclosure, the second printed circuit board 500 may be divided into a 2-1th flexible printed circuit board 500-1 and a 2-2th flexible printed circuit board 500-2, similar to the first printed circuit board 300 divided into the 1-1th printed circuit board 310 and the 1-2th printed circuit board 320. The division structure of the second printed circuit board 500 provided in the disclosure may be an appropriate response to the trend of increasing lines to the electronic device 101 as well as the purpose of reducing noise signals for the fourth line 502 (e.g., an RF line).

Referring to FIG. 9A, according to an embodiment, the second printed circuit board 500 may connect the third line 501 (e.g., logic line) and the fourth line 502 (e.g., RF line) to the main circuit board through the first printed circuit board 300 via different connectors 507 and 508, respectively. For convenience of description, the connector 507 for connecting the third line 501 may be referred to as a logic connector, and the connector 508 for connecting the fourth line 502 may be referred to as an RF connector. FIG. 9A may illustrate that the third line 501 and the fourth line 502 are branched from substantially one printed circuit board toward the two different connectors 507 and 508. In this case, the third line 501 and the fourth line 502 may be disposed on different printed circuit boards, i.e., the 2-1th flexible printed circuit board 500-1 and the 2-2th flexible printed circuit board 500-2 to extend to the different connectors 507 and 508.

Referring to FIG. 9A, the 2-1th flexible printed circuit board 500-1 and the 2-2th flexible printed circuit board 500-2 may be disposed to be spaced apart from each other by a predetermined distance along the width direction (e.g., the X-axis direction) of the electronic device. However, the disclosure is not necessarily limited thereto, and as shown in FIG. 9B, the 2-1th flexible printed circuit board 500-1 and the 2-2th flexible printed circuit board 500-2 may at least partially overlap each other in the height direction (e.g., the Z-axis direction) of the electronic device, and may be disposed to be spaced apart from each other by a predetermined distance in the height direction (e.g., the Z-axis direction). Accordingly, the connector 507 for connecting the third line 501 and the connector 508 for connecting the fourth line 502 may also overlap each other in the height direction (e.g., the Z-axis direction) and may be disposed to be spaced apart from each other by a predetermined distance in the height direction (e.g., the Z-axis direction).

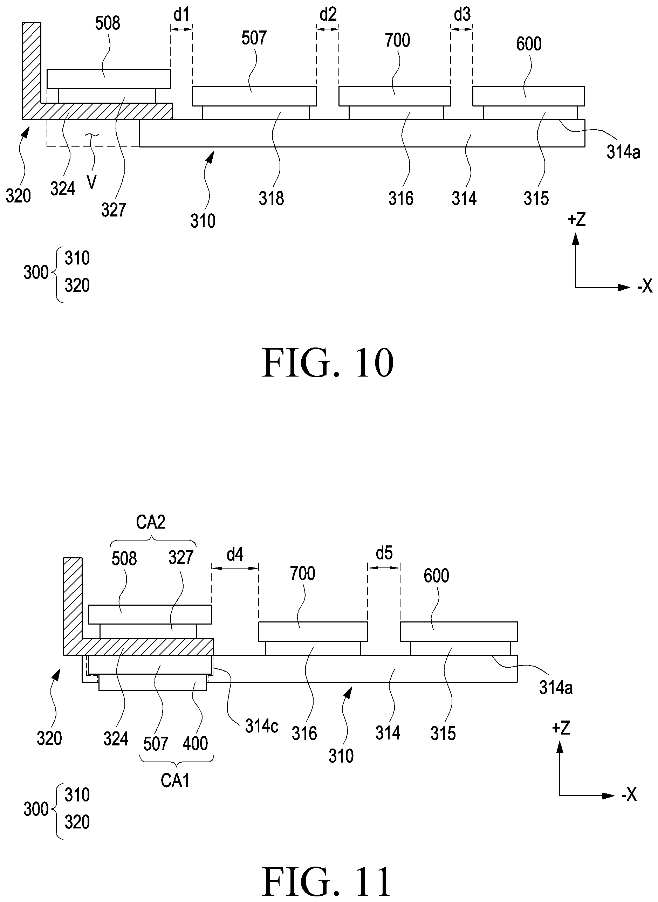

FIG. 10 is a view illustrating an arrangement structure of various connectors disposed on a 1-1th flexible printed circuit board according to an embodiment. FIG. 11 is a view illustrating an arrangement structure of various connectors including a first connector assembly disposed on a 1-1th flexible printed circuit board according to an embodiment.

According to an embodiment, the 1-1th flexible printed circuit board 310 may be electrically connected to the second printed circuit board 500 through a connector disposed on the second rigid portion 314.

According to the embodiment shown in FIG. 10, a plurality of connectors 315, 316, and 318 may be disposed on the second rigid portion 314 of the 1-1th flexible printed circuit board 310. For example, the plurality of connectors 315, 316, and 318 may be connectors connected to lines that transfer signals having different signal characteristics. Here, the lines may be, e.g., power line, MFC line, and logic line. Here, the MFC line may be a line for transferring signals related to magnetic secure transmission (MST), near-field communication (NFC), and wireless power charge (WPC). The lines may be connected to a plurality of connectors 315, 316, and 318, respectively, disposed side by side apart at a predetermined distance apart from each other along a width direction (e.g., an X-axis direction) of the electronic device on the second rigid portion 314. For convenience of description, the plurality of connectors 315, 316, and 318 may be denoted as a power connector, an MFC connector, and a logic connector, respectively, but it should be noted that this is exemplary. According to an embodiment, the plurality of connectors 315, 316, and 318 may be disposed side by side along the width direction (X-axis direction) of the electronic device 101 on the second rigid portion 314 of the 1-1th flexible printed circuit board 310.

Referring to FIG. 10, at least one connector 327 may be disposed on the fourth rigid portion 324 of the 1-2th flexible printed circuit board 320. For example, the at least one connector 327 may be a connector connected to an RF line. Accordingly, the connector 327 disposed on the 1-2th flexible printed circuit board 320 may be denoted as an RF connector, but it should be noted that this is exemplary. At least one connector 327 disposed on the 1-2th flexible printed circuit board 320 may be disposed on substantially the same plane as the plurality of connectors 315, 316, and 318 disposed on the 1-1th flexible printed circuit board 310. Here, when a connector (e.g., at least one connector 327) is disposed on substantially the same plane as other connectors (e.g., the plurality of connectors 315, 316, and 318), it may mean that the heights of the connectors 315, 316, 318, and 327 are formed within a step range of a predetermined height from the first surface 314a of the second rigid portion 314. For example, here, the 'step range of the predetermined height' may correspond to, e.g., the height (or thickness) of the fourth rigid portion 324. When the plurality of connectors 315, 316, and 318 disposed on the 1-1th flexible printed circuit board 310 and at least one connector 327 disposed on the 1-2th flexible printed circuit board 320 are disposed on substantially the same plane (level), the connectors 315, 316, 318, and 327 may be disposed side by side along the width direction (e.g., the X-axis direction) of the electronic device.

According to an embodiment, the electronic device 101 may include a plurality of connectors 600, 700, 507, and 508 configured to be respectively coupled to the plurality of connectors 315, 316, 318, and 327 disposed on the 1-1th flexible printed circuit board 310 and the 1-2th flexible printed circuit board 320 as described above. When the plurality of connectors 315, 316, 318, and 327 disposed on the 1-1th flexible printed circuit board 310 and the 1-2th flexible printed circuit board 320 are female connectors, the plurality of connectors 600, 700, 507, and 508 coupled thereto may be male connectors. On the contrary, when the plurality of connectors 315, 316, 318, and 327 disposed on the 1-1th flexible printed circuit board 310 and the 1-2th flexible printed circuit board 320 are male connectors, the plurality of connectors 600, 700, 507, and 508 coupled thereto may be female connectors. When the male connector and the female connector are coupled to each other, a complete single connector structure capable of conducting signals may be configured. According to the disclosure, a configuration in which a male connector and a female connector are coupled to each other may be denoted as a connector assembly. According to an embodiment, in one connector structure (or connector assembly), the male connector may be denoted as a header or a plug, and the female connector may be denoted as a receptacle or a socket.

The fourth rigid portion 324 of the 1-2th flexible printed circuit board 320 may be disposed to partially overlap the second rigid portion 314 of the 1-1th flexible printed circuit board 310. In this case, the second rigid portion 314 and the fourth rigid portion 324 may be disposed on substantially the same plane, and the plurality of connectors 315, 316, 318, and 327 may be disposed thereon side by side. In terms of space mountability inside the electronic device 101, the lengths of the second rigid portion 314 and the fourth rigid portion 324 of the 1-1th flexible printed circuit board 310 may be limited for efficient space utilization. Accordingly, the space for placing the plurality of connectors 315, 316, 318, and 327 on the second rigid portion 314 and the fourth rigid portion 324 may also be limited. For example, the gap between the plurality of connectors may be derived by averaging the sum d1+d2+d3 of the gaps between two adjacent connectors among the plurality of connectors 315, 316, 318, and 327 shown in FIG. 10, and noise may be induced in the connector (e.g., the RF connector) if the average value of the derived is not sufficient. Further, when the fourth rigid portion 324 of the 1-2th flexible printed circuit board 320 is disposed to at least partially overlap on the second rigid portion 314 of the 1-1th flexible printed circuit board 310, the length of the 1-1th flexible printed circuit board 310 should be additionally secured by the space V of the rear surface of the 1-2th flexible printed circuit board 320, which may deteriorate efficient space utilization.

Hereinafter, the embodiment illustrated in FIG. 11 is described in detail in contrast to the embodiment illustrated in FIG. 10. In describing the embodiment of FIG. 11, content overlapping those of FIG. 10 may be omitted. FIG. 11 may illustrate a cross section taken along direction A-A' of the overlapping structure of the second rigid portion 314 and the second rigid portion 324 of FIG. 7B.

Referring to FIG. 11, the plurality of connectors 315, 316, and 400 of the 1-1th flexible printed circuit board 310 may be disposed on the second rigid portion 314. For example, the plurality of connectors 315, 316, and 400 may be connectors connected to lines that transfer signals having different signal characteristics. For example, the lines may be, e.g., power line, MFC line, and logic line. The lines may be connected to a plurality of connectors 315, 316, and 400, respectively, disposed side by side apart at a predetermined distance apart from each other along a width direction (e.g., an X-axis direction) of the electronic device on the second rigid portion 314. Referring to FIG. 11, e.g., one of the plurality of connectors 315, 316, and 400 disposed on the 1-1th flexible printed circuit board 310 is the connector connected to the power line, and may be coupled to the connector 600 connected from the battery 289 to transfer the power of the battery 289 to the main circuit board. As another example, another connector 316 among the plurality of connectors 315, 316, and 400 disposed on the 1-1th flexible printed circuit board 310 may be coupled to the connector 700 connected to the antenna member 271 to perform an MST function, an NFC function, and/or a wireless charging function, as a connector connected to the MFC line.

In the embodiments of FIGS. 11 and the subsequent figures, e.g., another connector 400 among the plurality of connectors 315, 316, and 400 disposed on the 1-1th flexible printed circuit board 310 may be, e.g., a connector connected to the logic line. According to the embodiment shown in FIG. 11, an opening 314c may be formed in the second rigid portion 314. A connector(s) may be disposed in the opening 314c. In the disclosure, a combination of the connectors disposed in the opening 314c may be denoted as a 'first connector assembly CA1'. Further, the female connector (or male connector) constituting the first connector assembly CA1 disposed in the opening 314c may be referred to as a first connector, and the male connector (or female connector) constituting the first connector assembly CA1 may be referred to as a second connector. According to an embodiment, one of the plurality of connectors 315, 316, and 400, e.g., a connector 400 for connecting the logic line, may correspond to the first connector.

According to an embodiment, the first connector and other connectors 315, 316, and 327 may be disposed side by side along the width direction (X-axis direction) of the electronic device 101 on the second rigid portion 314 of the 1-1th flexible printed circuit board 310 and the fourth rigid portion 324 of the 1-2th flexible printed circuit board 320. Referring to FIG. 11, at least one connector 327 may be disposed on the fourth rigid portion 324 of the 1-2th flexible printed circuit board 320. For example, the at least one connector 327 may be a connector for connecting the RF line. Accordingly, the connector 327 disposed on the 1-2th flexible printed circuit board 320 may be denoted as an RF connector, but it should be noted that this is exemplary. The connector 327 disposed on the 1-2th flexible printed circuit board 320 may be disposed on substantially the same plane as the plurality of connectors 315 and 316 disposed on the 1-1th flexible printed circuit board 310 while being disposed on the 1-2th flexible printed circuit board 320. According to an embodiment, the electronic device 101 may include a plurality of connectors 600, 700, 507, and 508 configured to be respectively coupled to the plurality of connectors 315, 316, 400, and 327 disposed on the 1-1th flexible printed circuit board 310 and the 1-2th flexible printed circuit board 320. When the plurality of connectors 315, 316, 400, and 327 disposed on the 1-1th flexible printed circuit board 310 and the 1-2th flexible printed circuit board 320 are female connectors, the plurality of connectors 600, 700, 507, and 508 corresponding thereto may be male connectors. On the contrary, when the plurality of connectors 315, 316, 400, and 327 disposed on the 1-1th flexible printed circuit board 310 and the 1-2th flexible printed circuit board 320 are male connectors, the plurality of connectors 600, 700, 507, and 508 coupled thereto may be female connectors.

In the embodiments of FIG. 11 and the subsequent figures, the connector 400 connected to the logic line may be denoted as the first connector 400. The connector 507 coupled corresponding thereto may be denoted as the second connector 507. The first connector 400 and the second connector 507 may be formed of a female connector and a male connector, or of a male connector and a female connector, respectively, constituting the first connector assembly CA1 disposed in the opening 314c. As the first connector 400 and the second connector 507 are disposed in the opening 314c, a contact point between the first connector 400 and the second connector 507 may also be formed in the opening 314c.

According to an embodiment of the disclosure, as shown in FIG. 11, the first connector 400 and the second connector 507 may be disposed in the opening 314c. According to an embodiment, the second connector 507 may be coupled while the first connector 400 is disposed in the opening 314c. As mentioned above, the first connector 400 and the second connector 507 may constitute the first connector assembly CA1. According to an embodiment, as the first connector assembly CA1 is disposed in the opening 314c, another connector assembly (e.g., the second connector assembly CA2) may be stacked on the first connector assembly CA1.

Referring to FIG. 11, in the electronic device 101, the length of the second rigid portion 314 of the 1-1th flexible printed circuit board 310 and the length of the fourth rigid portion 324 of the 1-2th flexible printed circuit board 320 may be limited for efficient internal space utilization. Accordingly, the space for placing the plurality of connectors on the second rigid portion 314 and the fourth rigid portion 324 may also be limited. The gap between the plurality of connectors 315, 316, and 400 may be derived by averaging the sum d4+d5 of the gaps between two adjacent connectors among the plurality of connectors shown in FIG. 11.

In the case of FIG. 11, the derived average of the gaps between the connectors may be larger than the average of the gaps between the connectors derived in FIG. 10. Accordingly, as a large gap is secured between the connectors, it is possible to reduce and/or prevent noise from being induced in the connector (e.g., RF connector 327). Further, according to an embodiment of FIG. 11, the 1-2th flexible printed circuit board 320 may be disposed to at least partially overlap on the 1-1th flexible printed circuit board 310 to connect a certain connector (e.g., RF connector 327) to the sub circuit board side. According to the embodiment of FIG. 11, the 1-2th flexible printed circuit board 320 may simply be superposed on the 1-1th flexible printed circuit board 310 without the need for additionally securing a space for disposing the 1-2th flexible printed circuit board 320, reducing and/or deleting the dead space.

FIG. 12 is a cross-sectional view illustrating an arrangement structure of a first connector assembly disposed on a first printed circuit board according to an embodiment.

Referring to FIG. 12, an electronic device 101 (e.g., the electronic device 101 of FIG. 1) according to an embodiment of the disclosure includes a first printed circuit board 300 including a first surface 314a, a second surface 314b opposite to the first surface 314a, and an opening 314c penetrating the first surface 314a and the second surface 314b. The electronic device 101 includes a first connector 400 and a second connector 507. At least a portion of the first connector 400 is disposed in the opening 314c, and at least a portion thereof is supported on the first surface 314a or the second surface 314b of the first printed circuit board 300, and the first connector 400 is electrically connected to the first printed circuit board 300. The second connector 507 is provided to the second printed circuit board 500. The second printed circuit board 500 is electrically connected to the first printed circuit board 300 through coupling of the first connector 400 and the second connector 507.

In an embodiment of FIG. 12, each of the first printed circuit board 300 and the second printed circuit board 500 may include a flexible printed circuit board (FPCB). Here, the first printed circuit board 300 may include a 1-1th flexible printed circuit board 310 and a 1-2th flexible printed circuit board 320, and the second printed circuit board 500 may include a 2-1th flexible printed circuit board 500-1 and a 2-2th flexible printed circuit board 500-2.

The 1-1th flexible printed circuit board 310 may include a second rigid portion 314, and an opening 314c may be formed in the second rigid portion 314. According to an embodiment, the opening 314c may penetrate the first surface 314a of the second rigid portion 314 and the second surface 314b facing in a direction opposite to the first surface 314a. According to an embodiment, the first surface 314a may be a surface facing the display 203 of FIG. 2 in the electronic device 101.

Referring to FIG. 12, the first connector 400 and the second connector 507 may be disposed in the opening 314c. The first connector 400 may include a first conductive portion P1. The first connector 400 may be electrically connected to the 1-1th flexible printed circuit board 310. The second connector 507 may include a second conductive portion P2. The second connector 507 is disposed in the opening 314c through insertion of the second conductive portion P2 toward the opening 3 14cs with in a state at least a portion of the second connector 507 facing a first surface 314a of the second rigid portion 314. The second connector 507 may be electrically connected to the second printed circuit board 500. According to an embodiment, the second printed circuit board 500 may include a connector 507 for connecting an RF line and a connector 508 for connecting a logic line at an end thereof, as referenced in FIGS. 9A and 9B. The connector 507 for connecting the RF line may correspond to the second connector 507 of FIG. 12.

Referring to FIG. 12, the first connector 400 may include a first plate 401, a first terminal portion 402, and a first conductive portion P1. The first connector 400 may be disposed in the opening 314c through insertion of the first conductive portion P1 toward the opening 314c with in a state at least a portion of the first connector 400 facing a second surface 314b of the second rigid portion 314. The first conductive portion P1 may be formed on one surface of the first plate 401. The first terminal portion 402 may be provided at a plurality of positions on the front surface of the first plate 401, and at least a portion thereof may contact the first conductive portion P1, and at least a portion thereof may contact the third terminal portion 314d provided on the second surface 314b of the second rigid portion 314 of the 1-1th flexible printed circuit board 310. According to an embodiment, the first terminal portion 402 may include a 1-1th terminal portion 402a that contacts the third terminal portion 314d to transfer an electrical signal or power, and a 1-2th terminal portion 402b that provides ground. For example, as shown in FIG. 12, the 1-1th terminal portion 402a may be disposed at a portion of the plate 401 facing the second surface 314b of the second rigid portion 314, and the 1-2th terminal portion 402b may be disposed at a portion facing the opening 314c. The ground portion P5 is connected to the 1-2th terminal portion 402b to prevent an electrical shock from occurring due to an excessive potential difference when the first connector 400 and the second connector 507 are coupled. However, the shape and/or arrangement of the first terminal portion 402, the first conductive portion P1, and/or the ground portion P5 is not necessarily limited to those shown in the drawings, but may vary according to embodiments.

Referring to FIG. 12, at least a portion of the first connector 400 may be supported on the second surface 314b of the first printed circuit board 300. The position of the first connector 400 is not necessarily limited thereto, and for example, it may be supported on the first surface 314a of the first printed circuit board 300. According to an embodiment, the first plate 401 of the first connector 400 may be supported on the first surface 314a or the second surface 314b of the first printed circuit board 300. A portion of the first plate 401 other than the portion overlapping the conductive portion P1 may at least partially contact and/or be supported on the first surface 314a or the second surface 314b while facing at least a portion of the first surface 314a or the second surface 314b. According to an embodiment, the first plate 401 may be supported in a connected (e.g., bonded) form using an adhesive with the first surface 314a or the second surface 314b. According to another embodiment, the first plate 401 may be supported on the first printed circuit board 300 as the first terminal portion 402 provided therein is connected to the third terminal portion 314d provided on the first surface 314a or the second surface 314b. Here, the first terminal portion 402 and the third terminal portion 314d may be soldered to each other. Although not shown in the drawings, when the first terminal portion 402 and the third terminal portion 314d are soldered to each other, a solder bump may be formed between the first terminal portion 402 and the third terminal portion 314d. According to another embodiment, the first plate 401 may be supported on the first printed circuit board 300 using a first reinforcing member 403 and/or a second reinforcing member 405, which is described below.

The first connector 400 of the disclosure may be disposed in advance before the second connector 507 is inserted into the opening 314c and contacts the first connector 400. When the assembly process of the electronic device 101 includes an assembly method of sequentially stacking components from bottom to top, it may be efficient to have a configuration supported on the second surface 314b, which is a lower surface of the first printed circuit board 300. Accordingly, the following description focuses primarily on an embodiment in which the first connector 400 is supported on the second surface 314b of the first printed circuit board 300.

The second connector 507 may include a second plate 507a, a second terminal portion 507b, and a second conductive portion P2. The second terminal portion 507b may be provided at a plurality of positions in the second plate 507a, and at least a portion thereof may contact the second conductive portion P2. The second terminal portion 507b may be electrically connected to the first terminal portion 402 through coupling (e.g., contact) between the first conductive portion P1 and the second conductive portion P2 to transfer various signals and/or power. The shape and/or arrangement of the second terminal portion 507b and the second conductive portion P2 may vary according to embodiments.

According to the disclosure, a contact point between the first conductive portion P1 and the second conductive portion P2 may be formed in the opening 314c. According to an embodiment, the first conductive portion P1 and the second conductive portion P2 may be firmly fastened to each other. Accordingly, the connection between the first conductive unit P1 and the second conductive unit P2 may be maintained even in a slide-in or slide-out operation of the electronic device 101 or other various operation(s). As the contact point between the first connector 400 and the second connector 507 is formed in the opening 314c, there is no need to separately include an area and/or a space for installing the first connector assembly CA1 on the surface (e.g., the first surface 314a) of the first printed circuit board 300 (e.g., the 1-1th flexible printed circuit board 310). In other words, the area and/or space for mounting components may be additionally secured by the area and/or space for installing the first connector assembly CA1. Meanwhile, other components or connectors may be disposed in the area and/or the space for mounting the first connector assembly CA1 to increase the efficiency of component arrangement in the electronic device 101.

For example, FIG. 12 illustrates a state in which another connector assembly is disposed overlapping the first connector assembly CA1 (i.e., the assembly of the first connector 400 and the second connector 507). The second connector assembly CA2 may be attached to the first connector assembly CA1 using an adhesive member 325 (e.g., a double-sided tape). The second connector assembly CA2 may include a third connector including a third conductive portion P3 and electrically connected to the 1-2th flexible printed circuit board 320 and a fourth connector including a fourth conductive portion P4 and electrically connected to the 2-2th flexible printed circuit board 500-2.

According to an embodiment, the second connector assembly CA2 may include a connector 327 for connecting to the RF line as a third connector, and a connector 508 fastened to the connector 327 as a fourth connector. Hereinafter, the connector 327 may be denoted as a third connector 327, and the connector 508 corresponding thereto may be denoted as a fourth connector 508. The fourth connector 508 may also be a connector for connection with the RF line. As another example, the RF signal transferred from the sub circuit board may be transferred to the main circuit board through the first printed circuit board 300. According to an embodiment, if the third connector 327 is an female connector, the fourth connector 508 may be a male connector to be fastened to the connector 327 for connection with the RF line. Conversely, e.g., if the third connector 327 is a male connector, the fourth connector 508 may be a female connector to be fastened to the third connector 327. The third connector 327 may include a third conductive portion P3, and the fourth connector 508 disposed at an end of the 2-2th flexible printed circuit board 500-2 may include a fourth conductive portion P4. Unlike the contact point between the first conductive portion P1 and the second conductive portion P2, disposed inside (e.g., the opening 314c) of the 1-1th flexible printed circuit board 310, the contact point between the third conductive portion P3 and the fourth conductive portion P4 may be disposed outside the 1-1th flexible printed circuit board 310. According to an embodiment, the third connector 327 and the fourth connector 508 may be disposed, outside the 1-1th flexible printed circuit board 310, side by side with other connector assemblies (e.g., the combination of the connector 315 and the connector 600, and the combination of the connector 316 and the connector 700) in one direction (e.g., the X-axis direction).

According to an embodiment, the first conductive portion P1 and the second conductive portion P2 may be formed of conductive fins. Further, the third conductive portion P3 and the fourth conductive portion P4 may also be formed of conductive fins. However, the disclosure is not necessarily limited thereto, and at least one of the first conductive portion P1, the second conductive portion P2, the third conductive portion P3, and the fourth conductive portion P4 may be another type of conductive port, rather than the conductive fin, as described below.

According to an embodiment, in the electronic device 101, in addition to, or instead of, stacking the second connector assembly CA2 on the first connector assembly CA1, another electronic component (e.g., the camera module 1000 of FIG. 22) may be disposed on the first connector assembly CA1.

According to an embodiment, the electronic device 101 may further include a recess portion 314e formed in a portion (e.g., one surface 314a of the second rigid portion 314) of the first printed circuit board 300 . For example, the second printed circuit board 500, which is a flexible printed circuit board, may be bent to contact one surface 314a of the second rigid portion 314 and be thus damaged (e.g., worn out). In order to reduce and/or prevent such damage, a recess portion 314e may be formed in the first printed circuit board 300 of the electronic device 101.

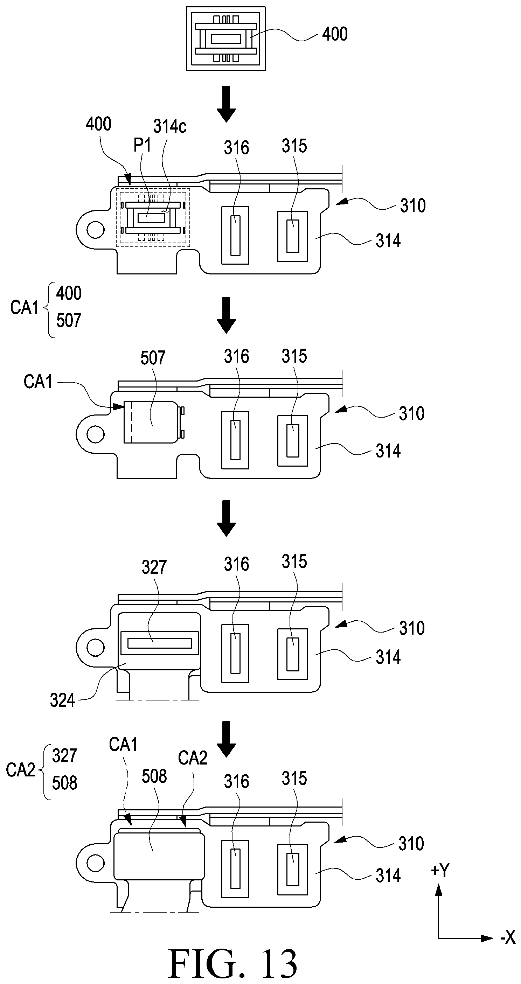

FIG. 13 is a view illustrating a process of disposing a first connector and another connector assembly on a 1-1th flexible printed circuit board according to an embodiment.

Referring to FIG. 13, first, the first connector 400 may be inserted into and fixed to the opening 314c formed in the second rigid portion 314 of the 1-1th flexible printed circuit board 310. In this case, the first conductive portion P1 of the first connector 400 may be positioned in the opening 314c. According to an embodiment, separately from the first connector 400, another connector(s) may also be disposed on the second rigid portion 314. After the first connector 400 is positioned in the opening 314c, the second connector 507 may be inserted into the opening 314c to fasten the second conductive portion of the second connector 507 to the first conductive portion of the first connector 400. While the second connector 507 is inserted into the opening 314c, another connector (e.g., the third connector 327) may be disposed at a position overlapping the first connector assembly CA1 (the first connector 400 and the second connector 507). Further, a connector (e.g., the fourth connector 508) paired with the other connector (e.g., the third connector 327) may be coupled to the other connector (e.g., the third connector 327).

In such a manner, as shown in FIG. 13, when the second rigid portion 314 of the 1-1th flexible printed circuit board 310 is viewed from above, the connectors 315 and 316 and the connector assembly CA2 are shown as disposed at three different positions but, in reality, as a connector (e.g., the connector assembly CA1) hidden by the second connector assembly CA2 is further included, the connectors 315 and 316 and the connector assemblies CA1 and CA2 may be disposed at four different positions.

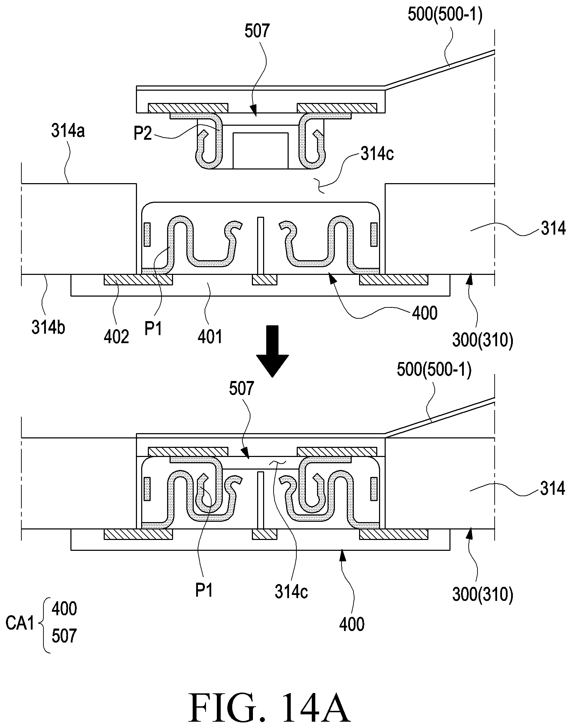

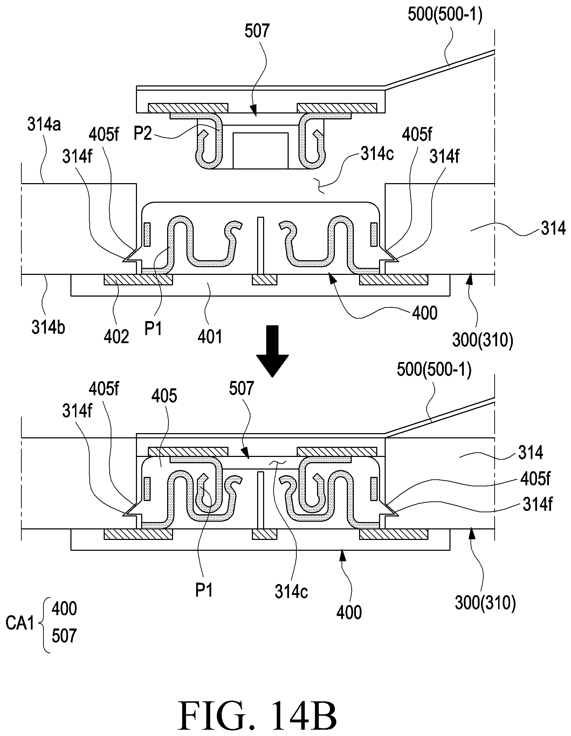

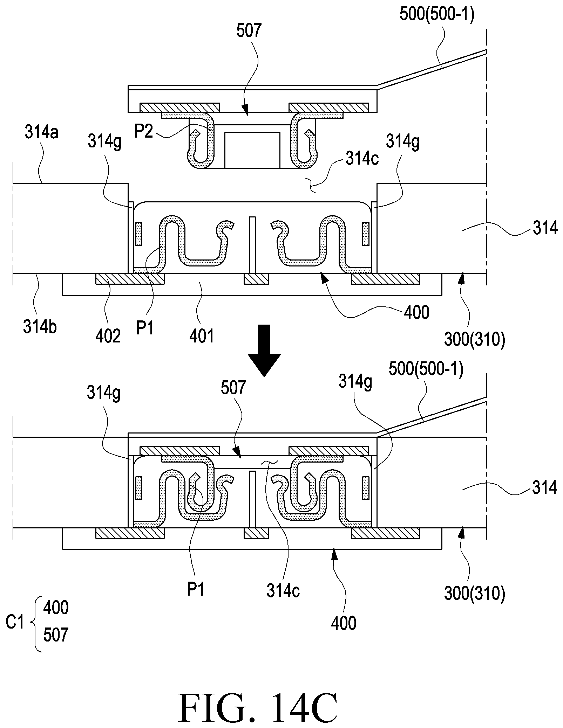

FIG. 14A is a cross-sectional view illustrating a state in which a first connector assembly is coupled according to an embodiment FIG. 14B is a cross-sectional view illustrating a state in which a first connector assembly is coupled according to an embodiment. FIG. 14C is a cross-sectional view illustrating a state in which a first connector assembly is coupled according to an embodiment.

Referring to FIGS. 14A to 14C, a state in which the first connector assembly CA1 is assembled to the opening 314c formed in the second rigid portion 314 of the 1-1th flexible printed circuit board 310 of the disclosure may be described in detail, according to various embodiments.

Referring to FIG. 14A, the first connector 400 may be disposed in the opening 314c before the second connector 507. Since the first conductive portion P1 protrudes from the first plate 401 toward a direction viewed by the first surface 314a of the second rigid portion 314, if the first connector 400 is disposed in the opening 314c, the first conductive portion P1 may face in the direction viewed by the first surface 314a. A portion of the first terminal portion 402 of the first connector 400 may be electrically connected to the 1-1th flexible printed circuit board 310 through the second surface 314b of the second rigid portion 314. According to an embodiment, the first connector 400 may be fixedly disposed in the opening 314c. Further, while the first connector 400 is disposed in the opening 314c, the second connector 507 may be disposed in the first opening 314c. The second conductive portion P2 of the second connector 507 may face in the direction viewed by the second surface 314b.

According to an embodiment, as the first conductive portion P1 and the second conductive portion P2 are engaged and coupled to each other in the opening 314c, the first printed circuit board 300 (e.g., the 1-1th flexible printed circuit board 310) and the second printed circuit board 500 (e.g., the 2-1th flexible printed circuit board 500-1) may be electrically connected. However, the contact point between the first conductive portion P1 and the second conductive portion P2 may not necessarily be limited as being in the opening 314c, and for example, as the height of the first conductive portion P1 of the first connector 400 extends to a position higher than that of the first surface 314a, the contact point between the first conductive portion P1 and the second conductive portion P2 may be formed at a position outside the opening 314c.

In the conventional art, assuming, e.g., FIG. 14A, in the connector, the first plate 401 portion of the first connector 400 is seated on the first surface 314a of the second rigid portion 314, and then the first conductive portion P1 protrudes toward the height direction from the first surface 314a (e.g., a form in which a receptacle has undergone surface mount technology (SMT)), and a connector (e.g., a header) corresponding thereto may be coupled thereto. In contrast, as shown in FIG. 14A, the disclosure may have a form in which the first conductive portion P1 is inserted toward the opening 314c reversely with respect to the second surface 314b of the second rigid portion 314. Further, the first conductive portion P1 may be inserted toward the opening 314c reversely with respect to the first surface 314a of the second rigid portion 314. From a point of view of such an inserted form, the embodiment of the disclosure may be denoted as a 'connector structure disposed reversely on a PCB' or a 'connector assembly disposed reversely on a PCB.'

Referring to FIG. 14B, the connector assembly and/or the electronic device including the same may further include a hook structure 314f and 405f. For example, In the first connector assembly CA1, if the first connector 400 is first disposed in the opening 314c, e.g., a hook portion 405f of the hook structure 314f and 405f is formed in the first connector 400, and a stepped portion 314f of the hook structure 314f and 405f may be formed in the first printed circuit board 300. According to an embodiment, while the first connector 400 is received in the opening 314c, the hook portion 405f of the first connector 400 may be slipped and received in the stepped portion 314f of the hook structure 314f. The hook structure 314f and 405f as included may be designed so that the first connector 400 may be easily received in the opening 314c but is difficult to separate simply by applying an external force. By including the hook structure 314f and 405f, it is possible to prevent the first connector 400 from escaping off the opening 314c by an external force applied when the second connector 507 is inserted into the opening 314c while the first connector 400 is first disposed and the second connector 507 is fastened.

FIG. 14B illustrates an example in which the hook portion 405f is formed on the first connector 400 in the first connector assembly CA1 including hook structure 314f and 405f, and the stepped portion 314f of the hook structure 314f and 405f is formed on the first printed circuit board 300. However, the disclosure is not necessarily limited thereto, and the stepped portion of the hook structure may be formed on the first connector 400 while the hook portion of the hook structure may be formed on the first printed circuit board 300. Alternatively, in any embodiment in which the second connector 507, rather than the first connector 400, is first disposed in the opening 314c, the hook portion (or stepped portion of the hook structure is formed on the second connector 507, and the stepped portion (or hook portion) of the hook structure corresponding thereto may be formed on the first printed circuit board 300.

In the connector assembly and/or the electronic device including the same, the terminal portion of the first printed circuit board 300 to be electrically connected to the first terminal portion 402 of the first connector 400 is not necessarily limited to the above-described example of FIG. 12.

Referring to FIG. 14B, the terminal portion of the first printed circuit board 300 to be electrically connected to the first terminal portion 402 of the first connector 400 may not be formed on the first surface 314a or the second surface 314b, but may be formed on an inner surface defining the opening 314c in the first printed circuit board 300. As shown in FIG. 14C, the fourth terminal portion 314g may be formed on the inner surface defining the opening 314c, which may be electrically connected to the terminal portion of the first connector 400. The fourth terminal portion 314g of FIG. 14C may be included in addition to or instead of the third terminal portion 314d described above in FIG. 12.

According to an embodiment, the first connector 400 may fit into the opening 314c where the fourth terminal portion 314g is formed, as shown in FIG. 14C, but is not necessarily limited thereto, and a spacing may be provided between the fourth terminal portion 314g and a side surface of the protruding structure of the first connector 400.

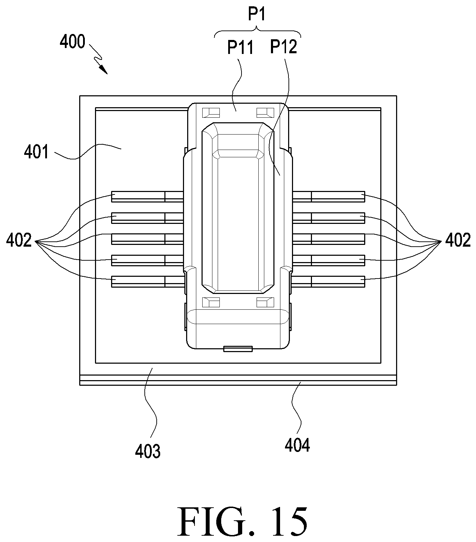

Hereinafter, various embodiments related to the first connector 400 are further described with reference to FIGS. 15 to 20.

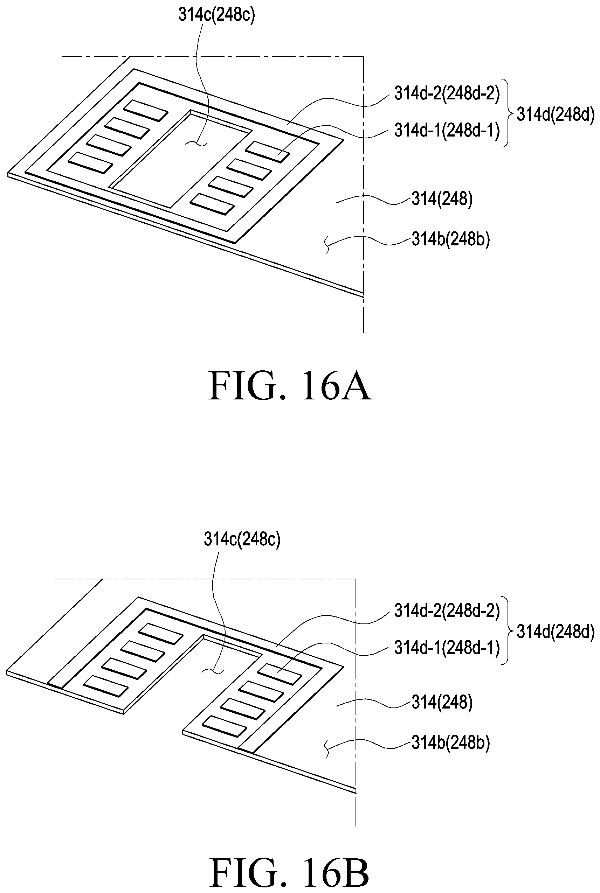

FIG. 15 is a perspective view illustrating a first connector according to an embodiment. FIGS. 16A to 16C are perspective views illustrating a second surface of a first rigid portion according to an embodiment.

Referring to FIG. 15, a first connector 400 may include a first plate 401, a first terminal portion 402, and a first conductive portion P1. According to an embodiment, the first connector 400 may further include a first reinforcing member 403 and a shielding member 404.

FIG. 15 illustrates an embodiment including a first plate 401 as the first connector 400. The first plate 401 may include a plurality of signal lines in addition to the first terminal portion 402, and may serve to support the first connector 400 on the counterpart (e.g., the first printed circuit board 300). The first plate 401 may have an area larger than that of the first conductive portion P1. The first terminal portion 402 of the first connector 400 may be a portion where a plurality of signal lines passing through the first plate 401 are exposed through one surface of the first plate 401 (to the outside if it is in a pre-assembly step). The first terminal portion 402 may be electrically connected to the terminal portion (e.g., the third terminal portion 314d) formed on the counterpart (e.g., the first printed circuit board 300) through a method such as soldering.

The first conductive portion P1 may include a body P11 and a port P12. Here, the body P11 may be formed of an injection-molded material such as synthetic resin, and the port P12 may include a metal material. The port P12 may be a portion formed on at least a portion of the body P11 and exposed (to the outside if it is in a pre-assembly step). Although not shown in detail in the drawings, a plurality of ports P12 may be disposed in parallel. For example, the port P12 may include a plurality of ports corresponding to the number of first terminal portions 402 formed on the first plate 401. According to an embodiment, the port P12 may be formed to partially penetrate the body P11.

FIG. 15 illustrates a header or a plug-shaped first conductive portion P1 as the first conductive portion P1, but is not necessarily limited thereto, and a receptacle or a socket-shaped first conductive portion may be applied.

Hereinafter, FIGS. 16A to 16C illustrate a first printed circuit board which is the counterpart of the first connector 400. It should be noted that, as the first printed circuit board, the first printed circuit board 300 in the form of an FPCB and the first printed circuit board 248 in the form of a PCB, as described above through the embodiment of FIG. 5, may apply. When the first printed circuit board 248 in the form of a PCB is applied, the first connector 400 of FIG. 15 may be replaced with a first connector 800 substantially identical to the first connector 400, as is described below in FIGS. 21 and 22.

Referring to FIG. 16A, the first printed circuit board 314 may include an opening 314c (or the opening 248c) formed in one surface (e.g., the second surface 314b (or the second surface 248b)) of the first printed circuit board 314 and a terminal portion 314d (or the terminal portion 248d) around the opening. According to an embodiment, the terminal portion 314d (or the terminal portion 248d) may include a terminal portion 314d-1 (or the terminal portion 248d-1) having a signal line, and a terminal portion 314d-2 (or the terminal portion 248d-2) surrounding the opening 314c (or the opening 248c) and the terminal portion 314d-1 (or the terminal portion 248d-1) having the signal line.

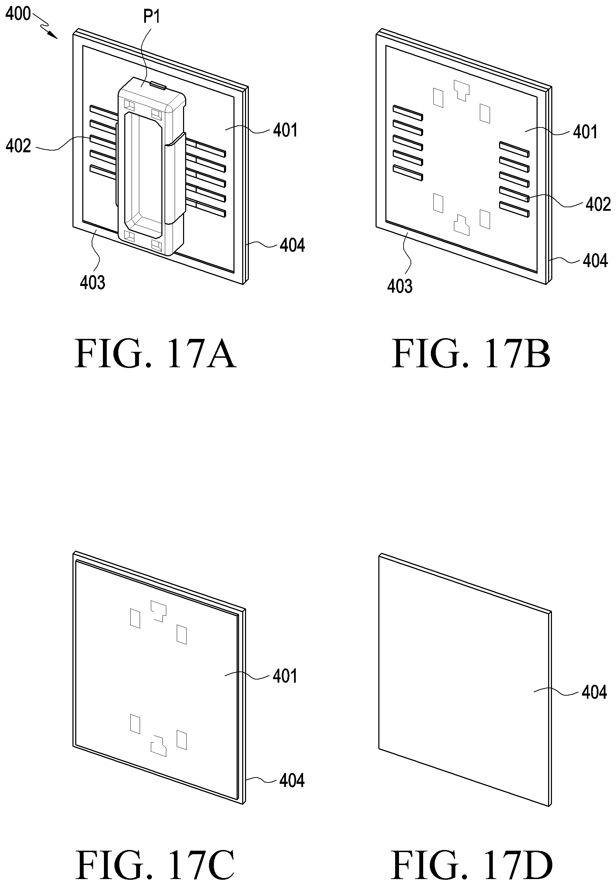

Referring to FIGS. 15 and 16A together, when the first connector 400 is coupled to the second surface 314b of the second rigid portion 314 of the 1-1th flexible printed circuit board 310, the first reinforcing member 403 may be provided for reinforcing the coupling strength and/or reinforcing the ground connection state. According to an embodiment, the first reinforcing member 403 may have a structure protruding from the first plate 401 in a height direction by a predetermined height, and may have a shape of being connected long along the edge of the first plate 401. According to an embodiment, the first reinforcing member 403 may be disposed to surround at least a portion of the first conductive portion P1 along an edge of the first plate 401. However, the shape of the first reinforcing member 403 is not limited to the embodiment of FIG. 15, and may be variously modified according to embodiments. According to an embodiment, referring to FIG. 16A, the second rigid portion 314 of the 1-1th flexible printed circuit board 310 may include a terminal portion 314d-1 corresponding to the first terminal portion 402 of the first connector 400 and a terminal portion 314d-2 corresponding to the first reinforcing member 403 on the second surface 314b. The shielding member 404 is described below with reference to embodiments of FIGS. 17A to 17D.

The shape of the opening 314c (or the opening 248c) is not limited to any specific embodiment. FIG. 16A shows a rectangular opening, but is not limited thereto. For example, referring to FIG. 16B, a shape in which one surface of the rectangular opening is pierced is shown, but other various forms may be applied. As the shape of the opening 314c (or the opening 248c) for receiving the first connector 400, a form in which four sides are blocked may be applied as shown in FIG. 16A, but in contrast, as shown in FIG. 16B, a form in which three sides are blocked, with at least one side open, may be applied.

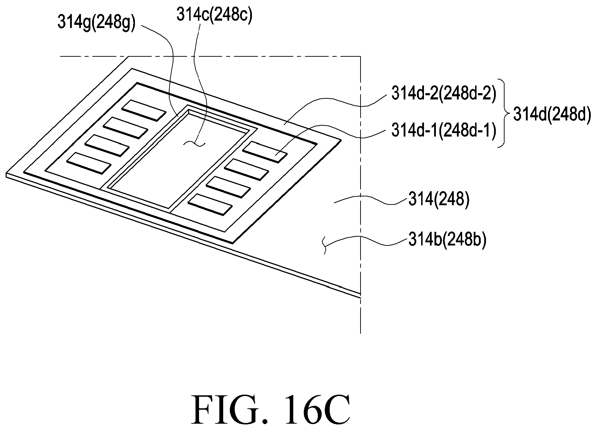

FIG. 16C illustrates an example in which a fourth terminal portion 314g (or the fourth terminal portion 248g) is formed on the inner surface defining the opening 314c in the first printed circuit board 300 described above with reference to FIG. 14C.

FIG. 17A is a perspective view illustrating a first connector according to an embodiment. FIG. 17B is a perspective view illustrating a portion except for a first conductive portion in a first connector according to an embodiment. FIG. 17C is a perspective view illustrating a portion except for a first conductive portion and a first terminal portion in a first connector according to an embodiment. FIG. 17D is a perspective view illustrating a portion except for a first conductive portion, a first terminal portion, and a first plate in a first connector according to an embodiment.

The structure of the first connector 400 and the shielding member 404 may be described in detail with reference to FIGS. 17A to 17D.

Referring to FIG. 17A, in the first connector 400, a conductive fin may be applied as the first conductive portion P1, but other various types of conductive ports may be applied. Referring to FIG. 17B, in which the first conductive portion P1 is omitted, the first connector 400 may have a plurality of first terminal portions 402 formed around the first conductive portion P1, and may have a form in which the first reinforcing member 403 surrounds the first conductive portion P1 along an edge of the first plate 401. Referring to FIGS. 17B and 17C together, the first plate 401 may be formed through, e.g., an injection-molding process, and the plurality of first terminal portions 402 and/or the first reinforcing member 403 may be formed thereon (on the front surface) by a process such as soldering. Referring to FIGS. 17C and 17D together, a shielding member 404 for noise shielding for the first connector 400 may be disposed on the rear surface of the first plate 401. The shielding member 404 may be designed to cover the entire rear surface of the first plate 401 by, e.g., plating, SUS, etc. on the rear surface of the first plate 401.

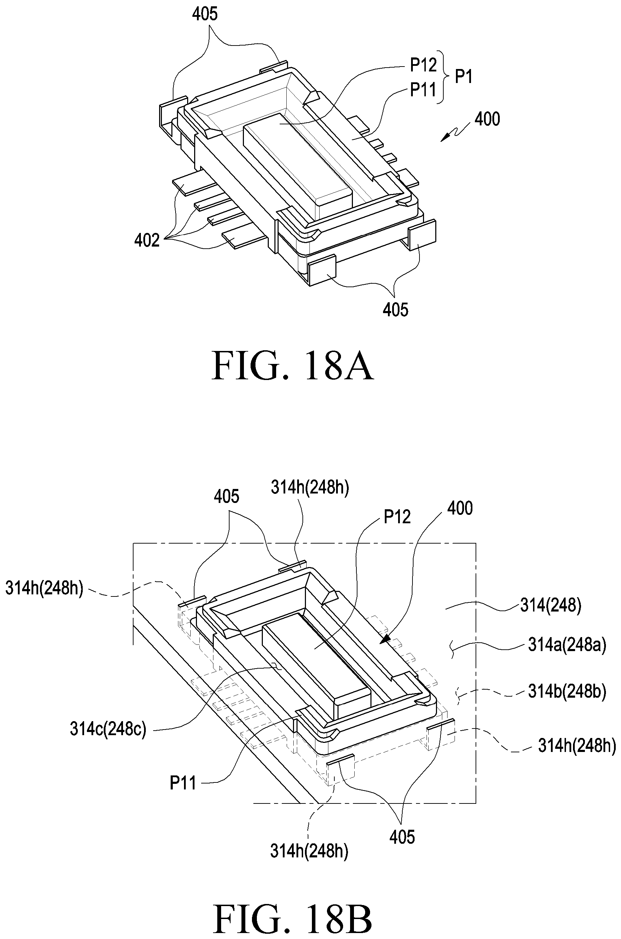

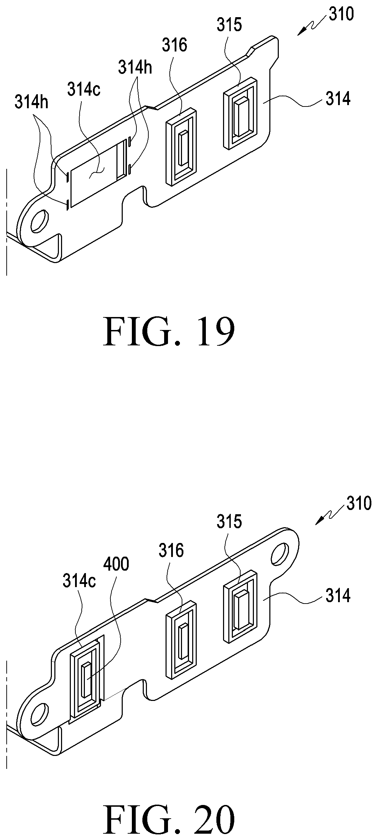

FIG. 18A is a perspective view illustrating a first connector further including a second reinforcing member according to an embodiment. FIG. 18B is a perspective view illustrating a state in which a first connector further including a second reinforcing member is coupled to a first rigid portion according to an embodiment. FIG. 19 is a perspective view illustrating a state of a first rigid portion further including an opening for a second reinforcing member according to an embodiment. FIG. 20 is a perspective view illustrating a state of a first rigid portion according to an embodiment.

FIGS. 18A and 18B illustrate a receptacle or a socket-shaped first conductive portion P1 as the first conductive portion P1, unlike embodiments of FIGS. 15 and 17A.

Referring to FIG. 18A, the first connector 400 may include a first terminal portion 402 and a first conductive portion P1. According to an embodiment, the first connector 400 may further include a first reinforcing member 406. Further, the first connector 400 may further include a shielding member (e.g., the shielding member 404 of FIG. 17D), but may be omitted hereinafter for convenience of description. According to an embodiment, the first plate (the first plate 401 in the embodiments of FIGS. 15 and 17A) may be omitted from the first connector 400. For example, in the embodiments of FIGS. 18A and 18B, unlike the above-described embodiments, the first plate (the first plate 401 in the embodiments of FIGS. 15 and 17A) is not provided in the first connector 400.

Referring to FIG. 18A, the first conductive portion P1 of the first connector 400 may include a body P11 and a port P12. Here, the body P11 may be formed of an injection-molded material such as synthetic resin, and the port P12 may include a metal material. The port (P12) may be exposed (to the outside in a pre-assembly step). The body P11 may be disposed around the port P12. Although not shown in detail in the drawings, a plurality of ports P12 may be disposed in parallel. For example, the port P12 may include a plurality of ports corresponding to the number of first terminal portions 402. According to an embodiment, the port P12 may be formed to partially penetrate the body P11.

Referring to FIGS. 18A and 18B, the first connector 400 may further include a second reinforcing member 405. According to an embodiment, the second reinforcing member 405 may be a hook-shaped structure that protrudes and extends from the edge of the body P11 of the first conductive portion P1 and then extends along the height direction of the first conductive portion P1. The second reinforcing member 405 may be provided to prevent the first connector 400 from escaping off the first printed circuit board 300. For example, the second reinforcing member 405 may be provided to prevent movement during a slide-in or slide-out operation of the electronic device after the first connector 400 is received in the opening 314c (or 248c) provided in the second rigid portion 314 of the 1-1th flexible printed circuit board 310. Referring to FIGS. 18B and 19, the second rigid portion 314 of the 1-1th flexible printed circuit board 310 may further include an opening 314h (or 248h) for the second reinforcing member in addition to the opening 314c. When the first connector 400 is received in the opening 314c (or 248c), the second reinforcing member 405 may be firmly fixed by being inserted into the opening 314h (or 248h) for the second reinforcing member.

The direction and/or position in which the first connector 400 is disposed on the second rigid portion 314 of the 1-1th flexible printed circuit board 310 may differ in each embodiment. For example, as illustrated in FIG. 19, the first connector 400 may be disposed so that the length direction of the first connector 400 is parallel to the length direction of the second rigid portion 314 or, as illustrated in FIG. 20, the first connector 400 may be disposed so that the length direction of the first connector 400 is perpendicular to the length direction of the second rigid portion 314.

Although not shown in the drawings, considering the durability of the 1-1th flexible printed circuit board 310, the position where the first connector 400 is disposed may correspond to a portion which is relatively larger in height (or thickness) than the other portions in the second rigid portion 314 of the 1-1th flexible printed circuit board 310. For example, in FIGS. 19 and 20, the second rigid portion 314 is depicted as a thin plate shape with a substantially constant thickness but, according to embodiments, the thickness of the second rigid portion 314 may differ according to the position. The thickness of the second rigid portion 314 at the position where the first connector 400 is disposed may be different from the thickness of the second rigid portion 314 at the position where another connector (e.g., the connectors 315 and 316) is disposed, and among them, the first connector 400 of the disclosure may be disposed on a portion having a larger thickness in the second rigid portion 314.

FIG. 21 is a cross-sectional view illustrating an arrangement structure of a first connector assembly disposed on a first printed circuit board according to an embodiment.

Referring to FIG. 21, an electronic device 101 (e.g., the electronic device 101 of FIG. 1) according to an embodiment of the disclosure includes a first printed circuit board 248 including a first surface 248a, a second surface 248b opposite to the first surface 248a, and an opening 248c penetrating the first surface 248a and the second surface 248b. The first printed circuit board 248 with the opening 248c allows for efficient space utilization. The opening 248c that penetrates both surfaces 248a and 248b enables other components, such as the connectors, to be embedded within the first printed circuit board 248, reducing the overall thickness of the electronic device 101. This contributes to compactness, allowing the integration of high-performance parts in a smaller form factor while providing enhanced portability for the device. The electronic device 101 includes a first connector 800 (e.g., the first connector 400 of FIG. 12) and a second connector 907. At least a portion of the first connector 800 is disposed in the opening 248c, and at least a portion thereof is supported on the first surface 248a or the second surface 248b of the first printed circuit board 248, and the first connector 400 is electrically connected to the first printed circuit board 248. The first connector 800 being partially disposed in the opening 248c of the first printed circuit board 248 ensures optimal space-saving by overlapping the first connector 800 with other components. This reduces the footprint required for connectors and enables better component density within the electronic device 101. The electrical connection between the first connector 800 and the first printed circuit board 248 ensures stable signal transmission, even when the electric device 101 includes moving parts, such as slidable or foldable displays. The second connector 907 is provided to the second printed circuit board 900. The second printed circuit board 900 is electrically connected to the first printed circuit board 248 through coupling of the first connector 800 and the second connector 907. The second printed circuit board 900 with the second connector 907 forms a reliable electrical connection with the first printed circuit board 248. This connection between the two circuit boards allows for stable data or power transfer across different parts of the electronic device 101. Moreover, the coupling of the first connector 800 and second connector 907 ensures a modular and adaptable structure, making it easier to design devices with slidable or foldable displays while maintaining electrical integrity.

In an embodiment of FIG. 21, each of the first printed circuit board 248 and the second printed circuit board 900 may include a rigid printed circuit board (RPCB) and a flexible printed circuit board (FPCB). According to an embodiment, the first printed circuit board 248 may correspond to the main circuit board or sub circuit board of FIG. 4. The second printed circuit board 900 may include a 2-1th flexible printed circuit board 910 (e.g., the 1-1th flexible printed circuit board 310 of FIG. 5) and a 2-2th flexible printed circuit board 920 (e.g., the 1-2th flexible printed circuit board 320 of FIG. 5).

An opening 248c may be formed in the first printed circuit board 248. According to an embodiment, the opening 248c may penetrate the first surface 248a of the first printed circuit board 248 and the second surface 248b facing in a direction opposite to the first surface 248a. According to an embodiment, the first surface 248a may be a surface facing the display 203 of FIG. 2 in the electronic device 101.

Referring to FIG. 21, the first connector 800 and the second connector 907 may be disposed in the opening 248c. The first connector 800 may include a first conductive portion P1. The first connector 800 may be electrically connected to the first printed circuit board 248. The second connector 907 may include a second conductive portion P2. The second connector 907 may be electrically connected to the second printed circuit board 900. The first printed circuit board 300 illustrated in FIG. 12 may be denoted as a second printed circuit board 900 in the embodiment of FIG. 21.

Referring to FIG. 21, the first connector 800 may include a first plate 801, a first terminal portion 802, and a first conductive portion P1. The first terminal portion 802 may be provided at a plurality of positions on the front surface of the first plate 801, and at least a portion thereof may contact the first conductive portion P1, and at least a portion thereof may contact the third terminal portion 248d provided on the second surface 248b of the first printed circuit board 248. According to an embodiment, the first terminal portion 802 may include a 1-1th terminal portion 802a that contacts the third terminal portion 248d to transfer an electrical signal or power, and a 1-2th terminal portion 802b that provides ground. For example, as shown in FIG. 21, the 1-1th terminal portion 802a may be disposed at a portion of the plate 801 facing the second surface 248b of the first printed circuit board 248, and the 1-2th terminal portion 802b may be disposed at a portion facing the opening 248c. The ground portion P5 is connected to the 1-2th terminal portion 802b to prevent an electrical shock from occurring due to an excessive potential difference when the first connector 800 and the second connector 907 are coupled. However, the shape and/or arrangement of the first terminal portion 802, the first conductive portion P1, and/or the ground portion P5 is not necessarily limited to those shown in the drawings, but may vary according to embodiments.

Referring to FIG. 21, at least a portion of the first connector 800 may be supported on the second surface 248b of the first printed circuit board 248. The position of the first connector 800 is not necessarily limited thereto, and for example, it may be supported on the first surface 248a of the first printed circuit board 248. According to an embodiment, the first plate 801 of the first connector 800 may be supported on the first surface 248a or the second surface 248b of the first printed circuit board 248. A portion of the first plate 801 other than the portion overlapping the conductive portion P1 may at least partially contact and/or be supported on the first surface 248a or the second surface 248b while facing at least a portion of the first surface 248a or the second surface 248b. According to an embodiment, the first plate 801 may be supported in a connected (e.g., bonded) form using an adhesive with the first surface 248a or the second surface 248b. According to another embodiment, the first plate 801 may be supported on the first printed circuit board 248 as the first terminal portion 802 provided therein is connected to the third terminal portion 248d provided on the first surface 248a or the second surface 248b. Here, the first terminal portion 802 and the third terminal portion 248d may be soldered to each other. According to another embodiment, the first plate 801 may be supported on the first printed circuit board 248 using a first reinforcing member (e.g., the first reinforcing member 403 of FIG. 15) and/or a second reinforcing member (e.g., the second reinforcing member 405 of FIG. 18A), which is described below.

The first connector 800 of the disclosure may be a component that is disposed in advance before the second connector 907 is inserted into the opening 248c and contacts the first connector 400. When the assembly process of the electronic device 101 includes an assembly method of sequentially stacking components from bottom to top, it may be efficient to have a configuration supported on the second surface 248b, which is a lower surface of the first printed circuit board 248. Accordingly, the following description focuses primarily on an embodiment in which the first connector 800 is supported on the second surface 248b of the first printed circuit board 248.

The second connector 907 may include a second plate 907a, a second terminal portion 907b, and a second conductive portion P2. The second terminal portion 907b may be provided at a plurality of positions in the second plate 907a, and at least a portion thereof may contact the second conductive portion P2. The second terminal portion 907b may be electrically connected to the first terminal portion 902 through coupling (e.g., contact) between the first conductive portion P1 and the second conductive portion P2 to transfer signals and/or power. The shape and/or arrangement of the second terminal portion 907b and the second conductive portion P2 may vary according to embodiments.

According to an embodiment, the second connector 907 may be disposed on the other surface 911b of one surface 911a and the other surface 911b of the first rigid portion 911 (e.g., the first rigid portion 311 of FIG. 5) of the 2-1th flexible printed circuit board 910 (e.g., the 1-1th flexible printed circuit board 310 of FIG. 5). According to an embodiment, the second connector 907 may be disposed on the other surface 921b of one surface 921a and the other surface 921b of the third rigid portion 921 (e.g., the third rigid portion 321 of FIG. 5) of the 2-2th flexible printed circuit board 920 (e.g., the 1-2th flexible printed circuit board 320 of FIG. 5). Here, the other surface 911b (or the other surface 921b) of the first rigid portion 911 (or the third rigid portion 921) may face in a direction opposite to the direction in which the first surface 248a of the first printed circuit board 248 faces. The following description focuses primarily on an embodiment in which the second connector 907 is disposed on the 2-1th flexible printed circuit board 910, which may be applied to an embodiment in which the second connector 907 is disposed on the 2-2th flexible printed circuit board 920.

According to the disclosure, a contact point between the first conductive portion P1 and the second conductive portion P2 may be formed in the opening 248c. According to an embodiment, the first conductive portion P1 and the second conductive portion P2 may be firmly fastened to each other. Accordingly, the connection between the first conductive unit P1 and the second conductive unit P2 may be maintained even in a slide-in or slide-out operation of the electronic device 101 or other various operation(s). As the contact point between the first connector 800 and the second connector 907 is formed in the opening 248c, there is no need to separately include an area and/or a space for installing the first connector assembly CA1 on the surface (e.g., the first surface 248a) of the first printed circuit board 248. In other words, the area and/or space for mounting components may be additionally secured by the area and/or space for installing the first connector assembly CA1. Meanwhile, other components or connectors may be disposed in the area and/or the space for mounting the first connector assembly CA1 to increase the efficiency of component arrangement in the electronic device 101.

FIG. 21 does not illustrate a state in which the first connector assembly CA1 (i.e., another connector assembly (e.g., the second connector assembly) overlapping the assembly of the first connector 800 and the second connector 907) is disposed, but according to an embodiment, another connector assembly (e.g., the second connector assembly) may be disposed. In this case, the embodiment of FIG. 12 may be applied.

According to an embodiment, the electronic device 101 may further include a recess portion 248e formed in a portion (e.g., one surface 248a) of the first printed circuit board 248 . For example, the second printed circuit board 900, which is a flexible printed circuit board, may be bent to contact one surface 248a of the first printed circuit board 248 and be thus damaged (e.g., worn out). In order to reduce and/or prevent such damage, a recess portion 248e may be formed in the first printed circuit board 300 of the electronic device 101.

FIG. 22 is a cross-sectional view illustrating a state in which a component is disposed on a first connector according to an embodiment.

Referring to FIG. 22, the electronic device 101 may additionally have another electronic component (e.g., the camera module 1000) disposed on the first connector assembly CA1.

According to an embodiment, as the first connector 800 is disposed on the first opening 248c of the first printed circuit board 248, various components (e.g., the camera module 1000) may be disposed through the additionally secured space. Although not shown in the drawings, according to an embodiment, in the embodiment of FIG. 12, various components (e.g., the camera module 1000) of FIG. 22 may be disposed instead of the 1-2th flexible printed circuit board 320 and the second connector assembly CA2. Further, various usable examples of the additionally secured space may be included within the category of the disclosure.

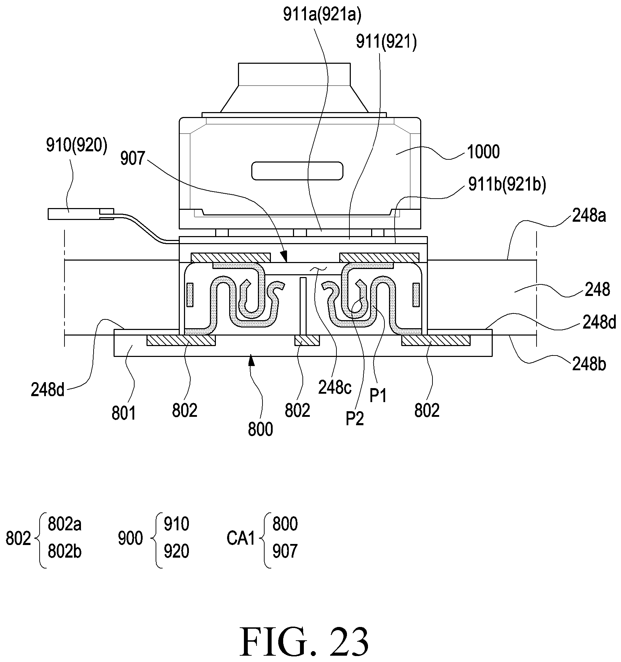

FIG. 23 is a cross-sectional view illustrating a state in which a component is disposed on a first connector according to an embodiment.

Referring to FIG. 23, according to an embodiment, the first connector assembly CA1 of the electronic device 101 may be disposed to be fitted onto the opening 248c (or the opening 314c), but is not necessarily limited thereto.

The first connector assembly CA1 may be disposed in a manner that if the contact point is formed on the opening 248c (or the opening 314c), a portion is exposed to the outside of the opening 248c (or the opening 314c). For example, as illustrated in FIG. 23, in the first connector assembly CA1, the contact point may be formed on the opening 248c (or the opening 314c) while a portion of the second plate 907a may be exposed to the outside of the opening 248c (or the opening 314c). According to an embodiment, at least a portion of the first connector assembly CA1 may have a shape of protruding outside the opening 248c (or the opening 314c).

According to an embodiment of the disclosure, as a connector is disposed in the opening 248c (or the opening 314c) of the printed circuit board (PCB) (or the flexible printed circuit board (FPCB)), it is possible to stack a plurality of connectors (or a connector assembly) in the height direction (e.g., the Z-axis direction) of the printed circuit board (PCB) (or the flexible printed circuit board (FPCB)), unlike disposing a plurality of connectors (or a connector assembly) side by side in one direction (e.g., the X-axis direction) on the plane, thereby making it possible to secure a component mounting space in the electronic device.

The electronic device according to various embodiments may be one of various types of devices. The electronic devices may include, for example, a portable communication device (e.g., a smartphone), a computer device, a portable multimedia device, a portable medical device, a camera, a wearable device, or a home appliance. The electronic devices according to an embodiment are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to an embodiment of the disclosure, an electronic device 101 may comprise a first printed circuit board 248; 300 including a first surface 248a; 314a, a second surface 248b; 314b opposite to the first surface 248a; 314a, and an opening 248c; 314c penetrating the first surface 248a; 314a and the second surface 248b; 314b; a first connector 400; 800 at least partially disposed in the opening 248c; 314c, at least partially supported on the first surface 248a; 314a or the second surface 248b; 314b of the first printed circuit board 248; 300, and electrically connected to the first printed circuit board 248; 300; and . The electronic device may comprise a second printed circuit board 500; 900 including a second connector 507; 907 and electrically connected to the first printed circuit board 248; 300 through coupling of the first connector 400; 800 and the second connector 507; 907.

According to an embodiment, each of the first printed circuit board 300 and the second printed circuit board 500 may include a flexible printed circuit board.

According to an embodiment, the first printed circuit board 300 may include a 1-1th flexible printed circuit board 310 including a first rigid portion 311, a second rigid portion 314, and a flexible portion 312, 313 between the first rigid portion 311 and the second rigid portion 314, and a 1-2th flexible printed circuit board 320 including a third rigid portion 321, a fourth rigid portion 324, and a flexible portion 322, 323 between the third rigid portion 321 and the fourth rigid portion 324.

According to an embodiment, a contact point between a first conductive portion P1 of the first connector 400 and a second conductive portion P2 of the second connector 507 may be formed in the opening 314c.

According to an embodiment, the first connector 400 may be disposed so that the first conductive portion P1 is inserted toward the opening 314c with at least a portion thereof facing a second surface 314b of the second rigid portion 314, and the second connector 507 may be disposed so that the second conductive portion P2 is inserted toward the opening 314c with at least a portion thereof facing a first surface 314a of the second rigid portion 314.

According to an embodiment, each of the first conductive portion P1 and the second conductive portion P2 may include a conductive pin, or a conductive port of a different form from the conductive pin.

According to an embodiment, the first connector 400 may include a first plate 401 and a first terminal portion 402 and a first conductive portion P1 formed on one surface of the first plate 401, and may include a first reinforcing member 403 disposed to surround at least a portion of the first conductive portion P1 along an edge of the first plate 401.

According to an embodiment, the first connector 400 may further include a second reinforcing member 405.

According to an embodiment, the 1-1th flexible printed circuit board 310 may include a power line, and the 1-2th flexible printed circuit board 320 may include an RF line.

According to an embodiment, the electronic device 101 may comprise a first housing part 201 and a second housing part 202 disposed to be movable relative to the first housing part 201.

According to an embodiment, the first printed circuit board 300 may be deformed when the second housing part 202 moves relative to the first housing part 201.

According to an embodiment, the electronic device may further comprise another connector overlapping the first connector 400 and the second connector 507 along a height direction e.g., A Z axis of the electronic device 100.

According to an embodiment, the first printed circuit board 248 may include a rigid printed circuit board, and the second printed circuit board 900 may include a flexible printed circuit board. According to an embodiment, the electronic device may comprise a first connector 800 electrically connected to the first printed circuit board 300 and a second connector 907 electrically connected to the second printed circuit board 900.

According to an embodiment, the electronic device may further comprise at least one component overlapping the first connector 400, 800 and the second connector 507, 907 along a height direction (e.g., a Z axis) of the electronic device 100.

According to an embodiment, the first connector 400, 800 may be a receptacle, and the second connector 507, 907 may be a header portion couplable to the first connector 400, 800, or the second connector 507, 907 may be a receptacle, and the first connector 400, 800 may be a header portion couplable to the second connector 507, 907.

According to an embodiment of the disclosure, an electronic device 101 may comprise a first printed circuit board 300 including an opening 314c, a first connector 400 disposed in the opening 314c, and a second printed circuit board 500 including a second connector 507 configured to be coupled with the first connector 400. The first connector 400 may include a first plate 401 and a first terminal portion 402 and a first conductive portion P1 formed on one surface of the first plate 401. The second connector 507 may include a second conductive portion P2 configured to contact the first conductive portion P1.

According to an embodiment, the first printed circuit board 300 may include a 1-1th flexible printed circuit board 310 including a line having a first signal characteristic and an opening 314c and a 1-2th flexible printed circuit board 320 including a line having a second signal characteristic different from the first signal characteristic. According to an embodiment, the second printed circuit board 500 may include a 2-1th flexible printed circuit board 500-1 electrically connected to the 1-1th flexible printed circuit board through coupling of the first connector 400 and the second connector 507.

According to an embodiment, the electronic device may further comprise a third connector 327 and a fourth connector 508 overlapping the first connector 400 and the second connector 507 along a height direction (e.g., a Z axis) of the electronic device 101.

According to an embodiment, the second printed circuit board 500 may include a 2-2th flexible printed circuit board 500-2 electrically connected to the 1-2th flexible printed circuit board through coupling of the third connector 327 and the fourth connector 508.

According to an embodiment of the disclosure, an electronic device 101 may comprise a first printed circuit board 248 including an opening 248c, a first connector 800 disposed in the opening 248c, and a second printed circuit board 900 including a second connector 907 configured to be coupled with the first connector 800. The first connector 800 may include a first plate 801 and a first terminal portion 802 and a first conductive portion P1 formed on one surface of the first plate 801. The second connector 907 may include a second conductive portion P2 configured to contact the first conductive portion P1.

According to an embodiment, the electronic device may comprise a first housing part 201 and a second housing part 202 disposed to be movable relative to the first housing part.

The second printed circuit board 500; 900 may be a flexible printed circuit board deformable according to a movement of the second housing part 202 relative to the first housing part 201.

While the disclosure has been described and shown in connection with an embodiment thereof, it should be appreciated that an embodiment is intended as limiting the invention but as illustrative. It will be apparent to one of ordinary skill in the art that various changes may be made in form and detail without departing from the overall scope of the disclosure, including the appended claims and their equivalents.

## Claims

1. An electronic device (101), comprising:
a first printed circuit board (248; 300) including a first surface (248a; 314a), a second surface (248b; 314b) opposite to the first surface (248a; 314a), and an opening (248c; 314c) penetrating the first surface (248a; 314a) and the second surface (248b; 314b);
a first connector (400; 800) at least partially disposed in the opening (248c; 314c), at least partially supported on the first surface (248a; 314a) or the second surface (248b; 314b) of the first printed circuit board (248; 300), and electrically connected to the first printed circuit board (248; 300); and
a second printed circuit board (500; 900) including a second connector (507; 907), and electrically connected to the first printed circuit board (248; 300) through coupling of the first connector (400; 800) and the second connector (507; 907).

2. The electronic device of claim 1,
wherein each of the first printed circuit board (300) and the second printed circuit board (500) includes a flexible printed circuit board.

3. The electronic device of claims 1 or 2,
wherein the first printed circuit board (300) includes:
a 1-1th flexible printed circuit board (310) including a first rigid portion (311), a second rigid portion (314), and a flexible portion (312, 313) between the first rigid portion (311) and the second rigid portion (314); and
a 1-2th flexible printed circuit board (320) including a third rigid portion (321), a fourth rigid portion (324), and a flexible portion (322, 323) between the third rigid portion (321) and the fourth rigid portion (324).

4. The electronic device of any one of claims 1 to 3,
wherein a contact point between a first conductive portion (P1) of the first connector (400) and a second conductive portion (P2) of the second connector (507) is formed at the opening (314c).

5. The electronic device of claim 4,
wherein the first connector (400) is disposed in the opening(314c) through insertion of the first conductive portion (P1) toward the opening (314c) with in a state at least a portion of the first connector (400) facing a second surface (314b) of the second rigid portion (314), and
wherein the second connector (507) is disposed in the opening(314c) through insertion of the second conductive portion (P2) toward the opening (314c) with in a state at least a portion of the second connector (507) facing a first surface (314a) of the second rigid portion (314).

6. The electronic device of claim 4,
wherein each of the first conductive portion (P1) and the second conductive portion (P2) includes a conductive pin, or a conductive port of a different shape from the conductive pin.

7. The electronic device of any one of claims 1 to 6,
wherein the first connector (400) includes a first plate (401) and a first terminal portion (402) and a first conductive portion (P1) formed on one surface of the first plate (401), and includes a first reinforcing member (403) disposed to surround at least a portion of the first conductive portion (P1) along an edge of the first plate (401).

8. The electronic device of any one of claims 5 to 7,
wherein the first connector (400) further includes a second reinforcing member (405).

9. The electronic device of claim 3,
wherein the 1-1th flexible printed circuit board (310) includes a power line, and the 1-2th flexible printed circuit board (320) includes an RF line.

10. The electronic device of any one of claims 1 to 9, further comprising:
a first housing part (201), and a second housing part (202) disposed to be movable relative to the first housing part (201).

11. The electronic device of claim 10,
wherein a shape of the first printed circuit board (300) is deformed when the second housing part (202) moves relative to the first housing part (201).

12. The electronic device of any one of claims 1 to 11, further comprising:
another connector overlapping the first connector (400) and the second connector (507) along a height direction of the electronic device (100).

13. The electronic device of claim 1,
wherein the first printed circuit board (248) includes a rigid printed circuit board, and the second printed circuit board (900) includes a flexible printed circuit board, and
wherein the electronic device comprises a first connector (800) electrically connected to the first printed circuit board (300) and a second connector (907) electrically connected to the second printed circuit board (900).

14. The electronic device of any one of claims 1 to 13, further comprising:
at least one component overlapping the first connector (400, 800) and the second connector (507, 907) along a height direction of the electronic device (100).

15. The electronic device of any one of claims 1 to 14,
wherein the first connector (400, 800) is a receptacle, and the second connector (507, 907) is a header portion configured to be coupled to the first connector (400, 800), or
wherein the second connector (507, 907) is a receptacle, and the first connector (400, 800) is a header portion configured to be coupled to the second connector (507, 907).
